(19) Europäisches Patentamt / European Patent Office / Office européen des brevets

(11) **EP 4 487 383 B1**

(12) **EUROPEAN PATENT SPECIFICATION**

(45) Date of publication and mention
of the grant of the patent:
**15.04.2026 Bulletin 2026/16**

(21) Application number: **23713788.0**

(22) Date of filing: **28.02.2023**

(51) International Patent Classification (IPC):
$H10F\ 10/162^{(2025.01)}$    $H10F\ 71/00^{(2025.01)}$
$H10F\ 77/123^{(2025.01)}$    $H10F\ 77/169^{(2025.01)}$
$H10F\ 77/30^{(2025.01)}$    $H10K\ 71/10^{(2023.01)}$
$H10K\ 30/84^{(2023.01)}$    $H10K\ 30/35^{(2023.01)}$

(52) Cooperative Patent Classification (CPC):
**H10F 77/311; H10F 10/162; H10F 71/125;
H10F 77/123; H10F 77/1696; H10K 30/35;
H10K 30/84; H10K 71/191**

(86) International application number:
**PCT/US2023/014110**

(87) International publication number:
**WO 2023/164284 (31.08.2023 Gazette 2023/35)**

(54) **PHOTOVOLTAIC DEVICES AND METHODS OF MAKING**

FOTOVOLTAISCHE VORRICHTUNGEN UND HERSTELLUNGSVERFAHREN

DISPOSITIFS PHOTOVOLTAÏQUES ET PROCÉDÉS DE FABRICATION

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **28.02.2022 US 202263314809 P**

(43) Date of publication of application:
**08.01.2025 Bulletin 2025/02**

(73) Proprietor: **First Solar, Inc.
Phoenix, AZ 85018 (US)**

(72) Inventors:
• **CAO, Duyen**
  **Perrysburg OH 43551 (US)**
• **GROVER, Sachit**
  **Perrysburg OH 43551 (US)**
• **HACK, James**
  **Perrysburg OH 43551 (US)**
• **LEE, Chungho**
  **Perrysburg OH 43551 (US)**
• **LU, Dingyuan**
  **Perrysburg OH 43551 (US)**
• **XIONG, Gang**
  **Perrysburg OH 43551 (US)**

(74) Representative: **D Young & Co LLP
3 Noble Street
London EC2V 7BQ (GB)**

(56) References cited:
**CN-A- 106 711 242**    **US-A1- 2008 023 677
US-A1- 2010 236 614**

• I-SHUO LIU ET AL: "Enhancing
photoluminescence quenching and
photoelectric properties of CdSe quantum dots
with hole accepting ligands", JOURNAL OF
MATERIALS CHEMISTRY, vol. 18, no. 6, 3
January 2008 (2008-01-03), GB, pages 675,
XP055755106, ISSN: 0959-9428, DOI: 10.1039/
b715253a
• ARIVARASAN AYYASWAMY ET AL: "Evaluation
of Reaction Parameters Dependent Optical
Properties and Its Photovoltaics Performances
of CdTe QDs", JOURNAL OF INORGANIC AND
ORGANOMETALLIC POLYMERS AND
MATERIALS, SPRINGER US, NEW YORK, vol. 28,
no. 3, 19 February 2018 (2018-02-19), pages 1263
- 1275, XP036481833, ISSN: 1574-1443, [retrieved
on 20180219], DOI: 10.1007/S10904-018-0803-1

**(Cont. next page)**

- LANDI B J ET AL: "CdSe quantum dot-single wall carbon nanotube complexes for polymeric solar cells", SOLAR ENERGY MATERIALS AND SOLAR CELLS, ELSEVIER SCIENCE PUBLISHERS, AMSTERDAM, NL, vol. 87, no. 1-4, May 2005 (2005-05-01), pages 733 - 746, XP027815188, ISSN: 0927-0248, [retrieved on 20050501]
- WANG WEINING ET AL: "PEDOT:PSS as back contact for CdTe solar cells and the effect of PEDOT:PSS conductivity on device performance", JOURNAL OF MATERIALS SCIENCE: MATERIALS IN ELECTRONICS, CHAPMAN AND HALL, LONDON, GB, vol. 27, no. 2, 9 October 2015 (2015-10-09), pages 1057 - 1061, XP035915042, ISSN: 0957-4522, [retrieved on 20151009], DOI: 10.1007/S10854-015-3850-1
- MAJOR J D ET AL: "P3HT as a pinhole blocking back contact for CdTe thin film solar cells", SOLAR ENERGY MATERIALS AND SOLAR CELLS, ELSEVIER SCIENCE PUBLISHERS, AMSTERDAM, NL, vol. 172, 16 July 2017 (2017-07-16), pages 1 - 10, XP085185367, ISSN: 0927-0248, DOI: 10.1016/J.SOLMAT.2017.07.005

## Description

### BACKGROUND

The present specification generally relates to layers for photovoltaic devices and, more specifically, to the use of particular combinations of materials and layer formation parameters to improve the efficiency of photovoltaic devices.

A photovoltaic device generates electrical power by converting light into electricity using semiconductor materials that exhibit the photovoltaic effect. A p-type contact with low contact resistivity and low recombinational loss has been an ongoing challenge in thin-film cadmium telluride based solar cell development. A lack of high work function materials with good band alignment makes it difficult to form an ohmic contact to p-type CdTe and other type II-VI semiconductor alloys. Material layers for improving efficiency of photovoltaic devices are desired.

Accordingly, a need exists for alternative layer structures and compositions for use in photovoltaic devices. Examples of related photovoltaic devices in the prior art are described in the publications I-Shuo Liu et al: "Enhancing photoluminescence quenching and photoelectric properties of CdSe quantum dots with hole accepting ligands", Journal of Materials Chemistry, vol. 18, no. 6, 3 January 2008, p. 675-682, Arivarasan Ayyaswamy et al: "Evaluation of Reaction Parameters Dependent Optical Properties and Its Photovoltaics Performances of CdTe QDs", JOURNAL OF INORGANIC AND ORGANOMETALLIC POLYMERS AND MATERIALS, vol. 28, no. 3, 19 February 2018, and US 2008/023677 A1.

### BRIEF DESCRIPTION OF THE DRAWINGS

The scope of the invention is defined in the accompanying claims. The embodiments set forth in the drawings are illustrative and exemplary in nature and not intended to limit the subject matter defined by the claims. The following detailed description of the illustrative embodiments can be understood when read in conjunction with the following drawings, wherein like reference numerals designate identical or corresponding parts throughout the views.

FIG. 1 schematically depicts a photovoltaic device according to one or more embodiments shown and described herein.

FIG. 2 schematically depicts a cross-sectional view of a segment of the photovoltaic device of FIG. 1 according to one or more embodiments shown and described herein.

FIGS. 3A-3B schematically depict cross-sectional views of a segment of photovoltaic devices according to embodiments shown and described herein.

FIG. 4 schematically depicts a cross-sectional view of formation of a self-assembled monolayer according to one or more embodiments shown and described herein.

FIGS. 5A-5B show shift in valence band offset for devices according to embodiments shown and described herein.

FIGS. 6A-6B show band diagrams for devices according to embodiments shown and described herein.

FIGS. 7A-7B show band diagrams for devices according to embodiments shown and described herein.

FIGS. 8A-8B show a comparison of performance characteristics for photoluminescence intensity with respect to peak wavelength of control devices and devices according to embodiments shown and described herein.

FIG. 9 shows a comparison of performance characteristics for devices according to embodiments shown and described herein.

FIGS. 10A-10E show comparative performance characteristics of control devices and devices according to embodiments shown and described herein.

### DETAILED DESCRIPTION

Photovoltaic devices can be formed from a stack of functional layers formed over a substrate. One or more of the functional layers can include a thin film of material, i.e., the photovoltaic device can be a thin film photovoltaic device. Thin film photovoltaic devices can include an absorber layer for converting light into charge carriers, and conductive layers for collecting the charge carriers. As charge carriers are generated, an electric potential is produced by the separation of charges. The positive and negative charge carriers, holes and electrons respectively, move in opposite directions, towards p-type and n-type regions on opposite sides of the absorber.

In thin-film cadmium telluride based solar cell development, producing a p-type contact with low contact resistivity and low recombinational loss has been an ongoing challenge. A lack of high work function materials with a good band alignment makes it difficult to form an ohmic contact to p-type CdTe, its alloys, and other type II-VI semiconductor alloys. Interface engineering with the described materials and methods provide an improved carrier extraction (ICE) layer between an absorber and a p-type contact layer to produce a structure with a high hole conductivity, a low electron affinity, chemical passivation, and controlled band alignment. Therefore, when the p-type majority carriers (holes) reach the contact interface, the ICE layer efficiently transports holes from the absorber to the p-type contact layer and minimizes interfacial recombination.

The ICE layer, in conjunction with the p-type contact layer, provides a good back contact to solar cells having an absorber comprising type II-VI semiconductor alloys, including alloys of cadmium and tellurium, including, binary, ternary, and quaternary alloys. The ICE layer maintains chemical passivation at a surface of the absorber layer and provides control of workfunction energy band alignment. The p-type contact layer has a low hole transport barrier and a high electron barrier for electron reflection. Ideally, the p-type contact layer has minimal interfacial defects, good passivation properties, and a high conductivity. The p-type contact layer may have a high doping for a deep Fermi level and a high hole mobility. In some instances, the ICE layer and the p-type contact layer can be formed towards the back side of the module with respect to the absorber layer. In some instances, the ICE layer and the p-type contact layer can be formulated to be substantially transparent. The embodiments provided herein relate to p-type contact layers and photovoltaic devices including the same. The disclosed layers can improve efficiency of current collecting portions of photovoltaic devices.

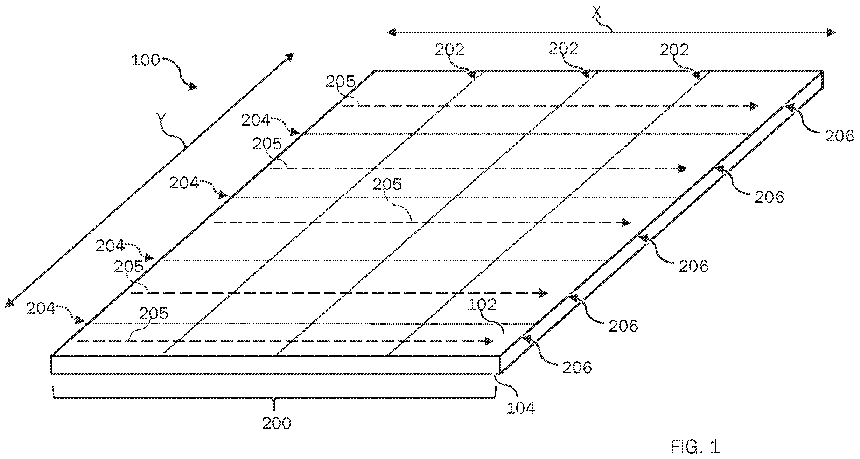

Referring now to FIG. 1, an embodiment of a photovoltaic device 100 is schematically depicted. The photovoltaic device 100 can be configured to receive light and transform light into electrical energy, e.g., photons can be absorbed from the light and transformed into electrical current via the photovoltaic effect. Thus, for sake of discussion and clarity, the photovoltaic device 100 can define a front side 102 configured to face a primary light source such as, for example, the sun. Additionally, the photovoltaic device 100 can also define a back side 104 offset from the front side 102 such as, for example, by a plurality of functional layers of material. It is noted that the term "light" can refer to various wavelengths of the electromagnetic spectrum such as, but not limited to, wavelengths in the ultraviolet (UV), infrared (IR), and visible portions of the electromagnetic spectrum. "Sunlight," as used herein, refers to light emitted by the sun.

The photovoltaic device 100 can include a plurality of layers disposed between the front side 102 and the back side 104. As used herein, the term "layer" refers to a thickness of material provided upon a surface. Each layer can cover all or a portion of an adjacent surface. In some embodiments, the layers of the photovoltaic device 100 can be divided into an array of photovoltaic cells 200. For example, the photovoltaic device 100 can be scribed according to a plurality of serial scribes 202 and a plurality of parallel scribes 204. The serial scribes 202 can extend along a length Y of the photovoltaic device 100 and demarcate the photovoltaic cells 200 along the length Y of the photovoltaic device 100. Neighboring cells of the photovoltaic cells 200 can be serially connected along a width X of the photovoltaic device 100. In other words, a monolithic interconnect of the neighboring cells 200 can be formed, i.e., adjacent to the serial scribe 202. The parallel scribes 204 can extend along the width X of the photovoltaic device 100 and demarcate the photovoltaic cells 200 along the width X of the photovoltaic device 100. Under operations, current 205 can predominantly flow along the width X through the photovoltaic cells 200 serially connected by the serial scribes 202. Under operations, parallel scribes 204 can limit the ability of current 205 to flow along the length Y. Parallel scribes 204 are optional and can be configured to separate the photovoltaic cells 200 that are connected serially into groups 206 arranged along length Y.

Referring still to FIG. 1, the parallel scribes 204 can electrically isolate the groups 206 of photovoltaic cells 200 that are connected serially. In some embodiments, the groups 206 of the photovoltaic cells 200 can be connected in parallel such as, for example, via electrical bussing. Optionally, the number of parallel scribes 204 can be configured to limit a maximum current generated by each group 206 of the photovoltaic cells 200. In some embodiments, the maximum current generated by each group 206 can be less than or equal to about 200 milliamps (mA) such as, for example, less than or equal to about 100 mA in one embodiment, less than or equal to about 75 mA in another embodiment, or less than or equal to about 50 mA in a further embodiment.

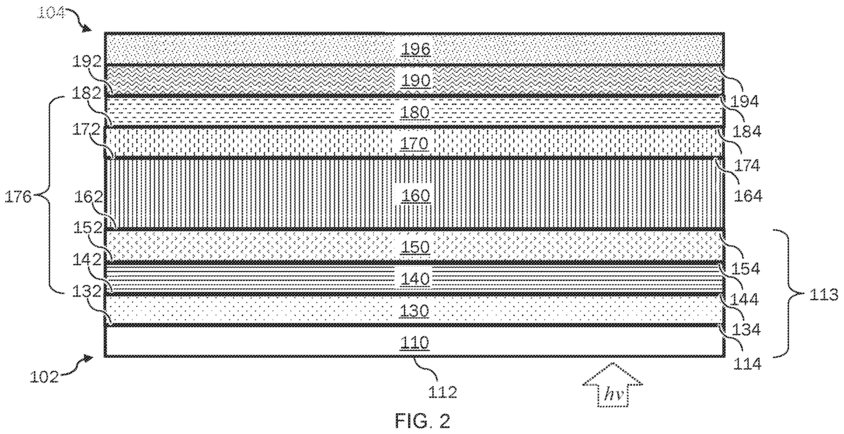

Referring now to FIG. 2, the layers of the photovoltaic device 100 can include a thin film stack provided over a substrate 110. The substrate 110 can be configured to facilitate the transmission of light into the photovoltaic device 100. The substrate 110 can be disposed at the front side 102 of the photovoltaic device 100. The substrate 110 can have a first surface 112 substantially facing the front side 102 of the photovoltaic device 100 and a second surface 114 substantially facing the back side 104 of the photovoltaic device 100. One or more layers can be disposed between the first surface 112 and the second surface 114 of the substrate 110.

The substrate 110 can include a transparent layer. The transparent layer can be a substantially transparent material such as, for example, glass. Suitable glass can include soda-lime glass, or a glass with reduced iron content. The transparent layer can have a transmittance range, for example, a range that includes visible light as well as near uv and/or infrared. In some embodiments, the transmittance range can include wavelengths from 250 nm to 1,300 nm, or subsets within that range. The transparent layer may also be characterized by a transmittance percentage, including, for example, more than about 50% in one embodiment, more than about 60% in another embodiment, more than about 70% in yet another embodiment, more than about 80% in a further embodiment, or more than about 85% in still a further embodiment. In one embodiment, the transparent layer can comprise a glass with about 90% transmittance, or more. Optionally, the substrate 110 can include a coating at the first surface 112. The coating can be configured to interact with light or to improve durability of the substrate 110 such as, but not limited to, an antireflective coating, an antisoiling coating, or a combination thereof.

Referring again to FIG. 2, the photovoltaic device 100 can include a barrier layer 130 configured to mitigate diffusion of contaminants (e.g., sodium) from the substrate 110, which could result in degradation or delamination of other layers of the photovoltaic stack. The barrier layer 130 can have a first surface 132 substantially facing the front side 102 of the photovoltaic device 100 and a second surface 134 substantially facing the back side 104 of the photovoltaic device 100. In some embodiments, the barrier layer 130 can be provided adjacent to the substrate 110. For example, the first surface 132 of the barrier layer 130 can be provided upon the second surface 114 of the substrate 100. The phrase "adjacent to," as used herein, means that two layers are disposed contiguously and without any intervening materials between at least a portion of the layers.

Generally, the barrier layer 130 can be substantially transparent, thermally stable, with a reduced number of pin holes and having high sodium-blocking capability, and good adhesive properties. Alternatively or additionally, the barrier layer 130 can be configured to apply color suppression to light. The barrier layer 130 can include one or more layers of material, including, but not limited to, tin oxide, silicon dioxide, aluminum-doped silicon oxide, silicon oxide, silicon nitride, or aluminum oxide. The barrier layer 130 can have a thickness bounded by the first surface 132 and the second surface 134, including, for example, more than 10.0 nm in one embodiment, more than about 15.0 nm in an embodiment, less than about 80.0 nm, or less than about 20.0 nm in a further embodiment.

Referring still to FIG. 2, the photovoltaic device 100 can include a n-type contact layer 140 configured to provide electrical contact to transport charge carriers generated by the photovoltaic device 100. The n-type contact layer can be a transparent conductive oxide (TCO) layer 140. The n-type contact layer 140 can have a first surface 142 substantially facing the front side 102 of the photovoltaic device 100 and a second surface 144 substantially facing the back side 104 of the photovoltaic device 100. In some embodiments, the n-type contact layer 140 can be provided adjacent to the barrier layer 130. For example, the first surface 142 of the n-type contact layer 140 can be provided upon the second surface 134 of the barrier layer 130. Generally, the n-type contact layer 140 can be comprise one or more layers of n-type semiconductor material that is substantially transparent and has a wide band gap. Specifically, the wide band gap can have a larger energy value compared to the energy of the photons of the light, which can mitigate undesired absorption of light. The n-type contact layer 140 can include one or more layers of material, including, but not limited to, tin dioxide, doped tin dioxide (e.g., F-$SnO_2$), indium tin oxide, or cadmium tin oxide, including cadmium stannate ($Cd_2SnO_4$). In embodiments where the n-type contact layer 140 comprises cadmium stannate, the cadmium stannate can be provided in a crystalline form. For example, the cadmium stannate can be deposited as a film and then subjected to an annealing process, which transforms the thin film into a crystallized film.

The photovoltaic device 100 can include a buffer layer 150 configured to provide an insulating layer between the n-type contact layer 140 and a semiconductor layer. The buffer layer 150 can have a first surface 152 substantially facing the front side 102 of the photovoltaic device 100 and a second surface 154 substantially facing the back side 104 of the photovoltaic device 100. In some embodiments, the buffer layer 150 can be provided adjacent to the n-type contact layer 140. For example, the first surface 152 of the buffer layer 150 can be provided upon the second surface 144 of the n-type contact layer 140. The buffer layer 150 can include material having higher resistivity than the n-type contact layer 140, including, but not limited to, intrinsic tin dioxide, zinc magnesium oxide (e.g., $Zn_{1-x}Mg_xO$), silicon dioxide ($SiO_2$), aluminum oxide ($Al_2O_3$), aluminum nitride (AlN), zinc tin oxide, zinc oxide, tin silicon oxide, or any combination thereof. In some embodiments, the material of the buffer layer 150 can be configured to substantially match the band gap of an adjacent semiconductor layer (e.g., an absorber). The buffer layer 150 may have a thickness between the first surface 152 and the second surface 154, including, for example, more than about 10.0 nm in one embodiment, between 10.0 nm and 120.0 nm, between 10.0 nm and 80.0 nm in an embodiment, or between 15.0 nm and 60.0 nm in a further embodiment.

Referring still to FIG. 2, the photovoltaic device 100 can include an absorber layer 160 configured to cooperate with another layer and form a p-n junction within the photovoltaic device 100. Accordingly, absorbed photons of the light can free electron-hole pairs and generate carrier flow, which can yield electrical energy.

A partly formed device, including a substrate 110, an n-type layer including a TCO layer 140 and/or a buffer layer 150, and layers therebetween, may be referred to as a substrate stack 113. The absorber layer 160 may be formed over the substrate stack 113. The absorber layer 160 has a first surface 162 facing the front side 102 of the photovoltaic device 100 and a second surface 164 facing the back side 104 of the photovoltaic device 100. A thickness of the absorber layer 160 can be defined between the first surface 162 and the second surface 164. The thickness of the absorber layer 160 can be between about 500 nm to about 10000 nm such as, for example, between about 1000 nm to about 7000 nm in one embodiment, or between about 1500 nm to about 4000 nm in another embodiment.

The absorber layer 160 can comprise a p-type semiconductor material having an excess of positive charge carriers, i.e., holes or acceptors. The absorber layer 160 can include a p-type semiconductor material such as group II-VI semiconductors such as, for example, cadmium and tellurium. Further examples include, but are not limited to, semiconductor materials comprising cadmium, zinc, tellurium, selenium, or any combination thereof. In some embodiments, the absorber layer 160 can include ternaries of cadmium, selenium and tellurium (e.g., $CdSe_xTe_{1-x}$), or a compound comprising cadmium, selenium, tellurium, and one or more additional element (e.g., $Cd_yZn_{1-y}Se_xTe_{1-x}$). The absorber layer 160 may further comprise one or more dopants. The photovoltaic devices 100 provided herein may include a plurality of absorber materials.

Alternately, in some embodiments, the absorber layer 160 can comprise an n-type semiconductor material having an excess of negative charge carriers, i.e., electrons or donors. The absorber layer 160 can include an n-type semiconductor material, including group II-VI semiconductors, for example, cadmium and selenium. In some embodiments, the absorber layer 160 is n-type cadmium selenide; in some embodiments the absorber layer can include ternaries of cadmium, selenium and tellurium, for example $CdSe_xTe_{1-x}$ wherein x is greater than 0.5; or a compound comprising cadmium, selenium, tellurium, and one or more additional element.

In embodiments where the absorber layer 160 is p-type and comprises tellurium and cadmium, the average atomic percent of the tellurium in the absorber layer 160 can be greater than or equal to about 25 atomic percent and less than or equal to about 50 atomic percent such as, for example, greater than about 30 atomic percent and less than about 50 atomic percent in one embodiment, greater than about 40 atomic percent and less than about 50 atomic percent in a further embodiment, or greater than about 47 atomic percent and less than about 50 atomic percent in yet another embodiment. Alternatively or additionally, average atomic percent of the tellurium in the absorber layer 160 can be greater than about 45 atomic percent such as, for example, greater than about 49% in one embodiment. It is noted that the average atomic percent described herein is representative of the entirety of the absorber layer 160, the atomic percentage of material at a particular location within the absorber layer 160 can be graded through the thickness compared to the overall composition of the absorber layer 160. For example, the absorber layer 160 can have a graded composition.

In embodiments where the absorber layer 160 is p-type and comprises selenium and tellurium, the average atomic percent of the selenium in the absorber layer 160 can be greater than 0 atomic percent and less or equal to than about 25 atomic percent such as, for example, greater than about 1 atomic percent and less than about 20 atomic percent in one embodiment, greater than about 1 atomic percent and less than about 15 atomic percent in another embodiment, or greater than about 1 atomic percent and less than about 8 atomic percent in a further embodiment. It is noted that the concentration of tellurium, selenium, or both can be graded through the thickness of the absorber layer 160. For example, when the absorber layer 160 comprises a compound including selenium at a mole fraction of x and tellurium at a mole fraction of 1-x ($Se_xTe_{1-x}$), x can vary in the absorber layer 160 with distance from the first surface 162 of the absorber layer 160. In an example absorber layer comprising $CdSe_xTe_{1-x}$, a mole fraction of selenium may be such that x is greater than 0 and less than 0.40; in some embodiments, x is less than 0.30 In some embodiments, the absorber layer comprises $CdSe_xTe_{1-x}$ and an average value of x in the absorber layer is less than 0.16.

Referring still to FIG. 2, the absorber layer 160 can be doped with a dopant configured to manipulate the charge carrier concentration. In some embodiments, the absorber layer 160 is doped p-type with a Group V dopant such as, for example, arsenic, phosphorous, antimony, or a combination thereof. Alternatively or additionally, the absorber layer 160 can be doped with a Group IB dopant such as, for example, copper, silver, gold, or a combination thereof. The total density of the dopant within the absorber layer 160 can be controlled. Moreover, the amount of the dopant can vary with distance from the first surface 162 of the absorber layer 160.

A p-n junction can be formed by the absorber layer and a layer having an opposite charge type. In a device with a p-type absorber layer, the p-n junction can be formed by providing the absorber layer 160 sufficiently close to a portion of the photovoltaic device 100 having an excess of negative charge carriers, i.e., electrons or donors. For example, a p-type absorber layer may be provided on an n-type TCO layer 140, optionally with an intervening buffer layer 150. In some embodiments, the absorber layer 160 can be provided adjacent to n-type semiconductor material. Alternatively, one or more intervening layers can be provided between the absorber layer 160 and n-type semiconductor material. In some embodiments, the absorber layer 160 can be provided adjacent to the buffer layer 150. For example, the first surface 162 of the absorber layer 160 can be provided upon the second surface 154 of the buffer layer 150. In some embodiments, the absorber layer 160 can be provided adjacent to the n-type contact layer 140. For example, the first surface 162 of the absorber layer 160 can be provided upon the second surface 144 of the n-type contact layer 140.

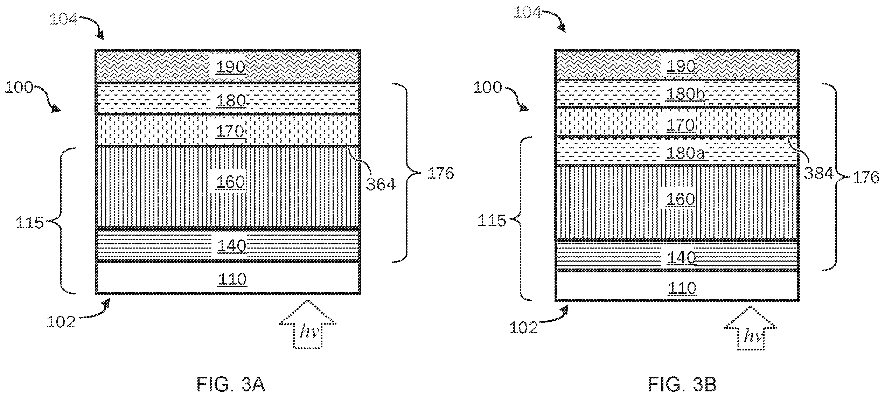

As shown in FIGS. 3A-3B, the photovoltaic device 100 can include the improved carrier extraction (ICE) layer 170 between the absorber layer 160 and a conductive layer 190. In the configuration shown in FIG. 3A, the improved carrier extraction (ICE) layer 170 can be positioned between the absorber layer 160 and a p-type contact layer 180. The ICE layer 170 has a first surface 172 facing the front side 102 of the photovoltaic device 100 and a second surface 174 facing the back side 104 of the photovoltaic device 100. The ICE layer 170 can be provided between the p-type contact layer 180 and the absorber layer 160. In some embodiments, the ICE layer 170 can be provided directly adjacent to one or both of the p-type contact layer 180 and the absorber layer 160. For example, as illustrated in FIG. 2 and FIG. 3A, the first surface 172 of the ICE layer 170 can be provided upon the second surface 164 of the absorber layer 160, and the second surface 174 of the ICE layer 170 can be adjacent to the first surface 182 of the p-type contact layer 180.

As shown in FIG. 3B, in an alternate configuration device can include a first p-type contact layer 180a between the absorber layer 160 and ICE layer 170; alternately or additionally, the device can include a second p-type contact layer 180b between the ICE layer 170 and the conductive layer 190.

A thickness of the ICE layer 170 can be defined between the first surface 172 and the second surface 174. A thickness of the ICE layer 170 can be greater than about 0.2 nm, such as for example, equal to or greater than 0.25 nm, equal to or greater than 0.3 nm, equal to or greater than 0.4 nm, equal to or greater than 0.5 nm, equal to or greater than 0.8 nm, equal to or greater than 1.0 nm, equal to or greater than 2.0 nm, or equal to or greater than 4.0 nm. The thickness of the ICE layer can be less than about 30 nm such as, for example, equal to or less than 25.0 nm, equal to or less than 20.0 nm, equal to or less than 15.0 nm, equal to or less than 10.0 nm, equal to or less than 5.0 nm, or equal to or less than 4.0 nm. In one example, the thickness of the ICE layer is between 0.3 nm and 6.0 nm. In another example, the thickness of the ICE layer is between about 0.4 nm and about 25 nm in one embodiment, or between about 0.5 nm and about 15 nm. In some embodiments, the thickness of the ICE layer 170 can be between about 0.2 nm to about 20 nm such as, for example, between about 0.2 nm to about 5.0 nm in one embodiment.

The ICE layer 170 may be formed from molecules of one or more organosulfur compounds. The ICE layer comprises a thiol-based molecule or a thiol derivative, such as a thiol alkane or a thiophene. The thiol-based molecule includes one or more of: cysteamine, also known as 2-aminoethanethiol (**AET**); 4-fluorothiophenol (**4-FTP**); 4-aminothiophenol (**4-ATP**); 1,2-ethanedithiol, also known as ethylene mercaptan (**EDT**); L-cysteine, also known as (R)-2-amino-3-mercaptopropionic acid (**L-Cys**); thioglycolic acid, also known as mercaptoacetic acid (**TGA**); 1-octanethiol (**OT**); 4-fluorobenzyl mercaptan, also known as (4-fluorophenyl)methanethiol (4-FBM); 3,3,4,4,5,5,6,6,7,7,8,8,8-tridecafluoro-1-octanethiol (**TDF-OT**); or 4-trifluoromethylbenzyl mercaptan (**4-TFMBM**). The ICE layer may consist of a thiol-based molecule which composes a reaction product or tautomeric form of one or more other molecules, including for example, isothiourea from tautomerization of thiourea. The ICE layer may consist of a thiol-based molecule produced from a salt form, including for example, sodium thiophenolate or sodium thioglycolate.

The photovoltaic device 100 can include a p-type contact layer 180 configured to provide electrical contact to the absorber layer 160. The p-type contact layer 180 can have a first surface 182 substantially facing the energy side 102 of the photovoltaic device 100 and a second surface 184 substantially facing the opposing side 104 of the photovoltaic device 100. The p-type contact layer 180 can be a back contact layer having a first surface 182 substantially facing the absorber layer 160. A thickness of the p-type contact layer 180 can be defined between the first surface 182 and the second surface 184. A thickness of the p-type contact layer 180 can be less than about 500 nm such as, for example, between about 0.5 nm and about 100 nm in one embodiment, or between about 5 nm and about 50 nm in another embodiment. In some embodiments, the thickness of the p-type contact layer 180 can be between about 5 nm to about 200 nm such as, for example, between about 10 nm to about 50 nm in one embodiment.

In some embodiments, the p-type contact layer 180, 180a, 180b is one or more layers comprising a polymer, small molecule, or inorganic compound. These materials can be doped to alter their electrical and optical properties.

In some embodiments, the p-type contact layer comprises an inorganic compound comprising one or more of a metal, an oxide, or a nitride. The p-type contact layer comprises an inorganic compound selected from: nickel oxide (NiOx), cuprous thiocyanate (CuSCN), copper iodide (CuI), or copper oxide (Cu$_2$O) or a polymer material selected from Poly[bis(4-phenyl)(2,4,6-trimethylphenyl)amine] (**PTAA**), Poly(9,9-dioctylfluorene-alt-N-(4-sec-butylphenyl)-diphenylamine) **(TFB),** Poly [(9,9-dioctylfluorenyl-2,7-diyl)-co-(4,4'-(N-(2,4-dimethylphenyl)) diphenylamine)] (**PF8-TAA**), Poly[[(2,4-dimethylphenyl)imino]-1,4-phenylene (6,12-dihydro6,6,12,12-tetraoctylindeno [1,2-b]fluorene-2,8-diyl)-1,4-phenylene] (**PIF8-TAA**), Poly(3-hexylthiophene-2,5-diyl) (**P3HT**), Poly(N,N'-bis-4-butylphenyl-N,N'-bisphenyl)benzidine (**PolyTPD**), Polythiophene, or Poly(3,4-ethylenedioxythiophene)-poly(styrenesulfonate) (**PEDOT:PSS**).

In some embodiments, the p-type contact layer comprises a small molecule selected from N2,N2,N2',N2',N7,N7,N7',N7'-octakis(4-methoxyphenyl)-9,9'-spirobi[9H-fluorene]-2,2',7,7'-tetramine (**Spiro-OMeTAD**), N2,N2,N2',N2',N7,N7,N7',N7'-octakis(4-methoxyphenyl)-10-phenyl-10H-spiro[acridine-9,9'-fluorene]-2,2',7,7'-tetraamine (**SAF-OMe**), N,N'-dialkyl perylenediimide (**PDI**), 4,4'-Bis(N-carbazolyl)-1,1'-biphenyl (**CBP**), Tris(4-carbazoyl-9-ylphenyl)amin (**TCTA**), 1,3,5- Tris(carbazol-9-yl)benzene (**TCP**), tris {N, N-bis (4-methoxyphenyl)-N-phenyl}amine quinolizino arcidine (**OMeTPA-FA**), **SGT-407, Fused-F,** or tetrathiafulvalene (**TTF-1**). In some embodiments the p-type contact layer comprises a material selected from: **alpha-NPD,** 6,13-bis(triisopropylsilylethynyl) pentacene (**TIPS-pentacene**), Poly [2,6- (4,4-bis-(2-ethylhexyl) -4H-cyclopenta [2,1-b;3,4-b'] dithiophene) -alt-4,7 (2,1,3-benzothiadiazole)] (**PCPDTBT**), Poly [N-9'-heptadecanyl-2,7-carbazole-alt-5,5-(4',7'-di-2-thienyl-2',1',3'-benzothiadiazole)] (**PCDTBT**), graphene oxide, and quinolizino acridine.

The compositions of the p-type contact layer may be doped. For example, p-type dopants for small molecule compositions can include but are not limited to: 2,3,5,6-Tetrafluoro-7,7,8,8-tetracyanoquinodimethane (F4-TCNQ), transition metal oxides such as molybdenum tri-oxide ($MoO_3$), vanadium pent-oxide ($V_2O_5$) or tungsten tri-oxide ($WO_3$), and molybdenum tris[1,2-bis(trifluoromethyl-)ethane-1,2-dithiolene] ($Mo(tfd)_3$).

A thin film junction 176 can be defined as the thin film stack primarily contributing to the photovoltaic effect. For example, in some embodiments, as illustrated in FIG. 2, the thin film junction 176 can include the n-type contact layer 140, the buffer layer 150, the absorber layer 160, the improved carrier extraction (ICE) layer 170, and the p-type contact layer 180. FIGS. 3A-3B show the thin film junction 176 comprising the layers between, and including, the n-type contact layer 140 and the p-type contact layer 180.

The photovoltaic device 100 can include a conducting or conductive layer 190 configured to provide electrical contact with the absorber layer 160. The conductive layer 190 can have a first surface 192 substantially facing the energy side 102 of the photovoltaic device 100 and a second surface 194 substantially facing the opposing side 104 of the photovoltaic device 100. In some embodiments, the conductive layer 190 can be provided adjacent to the p-type contact layer 180. For example, the first surface 192 of the conductive layer 190 can be provided upon the second surface 184 of the p-type contact layer 180. The conductive layer 190 can include a conducting material such as, for example, one or more layers of metal, oxide, oxynitride, nitride, nitrogen-containing metal, silver, nickel, copper, aluminum, titanium, palladium, chrome, molybdenum, gold, or the like. Examples of a nitrogen-containing metal layer can include nitrogen-doped zinc telluride, nitrogen-doped cadmium zinc telluride, nitrogen-doped zinc oxide, molybdenum nitride, molybdenum oxynitride, aluminum nitride, nickel nitride, titanium nitride, tungsten nitride, selenium nitride, tantalum nitride, or vanadium nitride. The conductive material may include one or more metal elements. The conductive material may include a metal alloy, a nitride, an oxide, and/or an oxynitride. The conductive material may have sublayers of differing compositions.

The photovoltaic device 100 can include a back support 196 configured to cooperate with the substrate 110 to form a housing for the photovoltaic device 100. The back support 196 can be disposed at the opposing side 102 of the photovoltaic device 100. For example, the back support 196 can be formed adjacent to conductive layer 190. The back support 196 can include, for example: glass, polymer sheeting, borosilicate glass, float glass, soda lime glass, carbon fiber, or polycarbonate.

Referring collectively to FIGS. 1-3, a substrate stack 113 of the photovoltaic device 100 is positioned toward the light-facing front side 102 and opposite the back side 104. The layers comprising the substrate stack 113 are substantially transparent. The absorber layer is provided over the substrate stack 113 to form an absorber stack 115.

In some embodiments, a partly-formed device comprising the layer stack 115 can be subjected to one or more surface treatments to modify a surface region 364 of the absorber layer 160 at a back interface. The surface region 364 of the absorber layer may include a portion of the absorber layer 160 at the second surface 164 and extending into the thickness of the absorber layer 160. In an embodiment, the surface region 364 comprises a top surface of the absorber stack 115, extending into the absorber layer 160 to a depth of about 10 nm, about 5 nm, or in a range of 0.2 nm to 15 nm. In an embodiment, the surface region 364 is passivated by the treatment. In an embodiment, the surface region 364 is a Cd-rich layer. In an embodiment, the surface region 364 comprises cadmium and tellurium and a ratio of Cd to Te in the surface region 364 is in a range from 1:1 to 4:1.

In some embodiments, a partly-formed device comprising the layer stack 115 can be subjected to one or more surface treatments to modify a surface region 384 of the first p-type contact layer 180a at a back interface. The surface region 384 of the first p-type contact layer may include a portion of the first p-type contact layer 180a at the second surface 184 and extending into the thickness of the p-type contact layer 180a. In an embodiment, the surface region 384 comprises a top surface of the absorber stack 115, extending into the first p-type contact layer 180a to a depth in a range from 0.01% to 10.0% of the thickness of the first p-type contact layer 180a thickness. In an embodiment, the surface region 384 is passivated by the treatment.

The photovoltaic device 100 can include a plurality of layers and, where layers are not specified as adjacent, the photovoltaic device may include intervening layers not depicted. Layers can include one or more functional layers of material and a single layer may have a compositional gradient therein. A deployment-ready device may further include electrical connections, encapsulation, and other features.

Photovoltaic devices may contain several material layers deposited sequentially over a substrate. Steps for manufacturing a photovoltaic device may include sequentially disposing functional layers or layer precursors in a "stack" of layers through one or more deposition processes, including, but not limited to, spin coating, spray coating, slot coating, blade coating, dip coating, sputtering, evaporation, molecular beam deposition, pyrolysis, closed space sublimation (CSS), pulse laser deposition (PLD), chemical vapor deposition (CVD), electrochemical deposition (ECD), atomic layer deposition (ALD), or vapor transport deposition (VTD). The as-deposited layer or layer stack may be treated or processed to modify characteristics using one or more methods, for example, by annealing, passivating, heating, vapor contact, or chemical treatment. Manufacturing of photovoltaic devices can further include the selective removal of portions of certain layers of the stack of layers, such as by scribing, to divide the photovoltaic device into a plurality of photovoltaic cells.

Surface treatment of a top surface of the absorber stack, prior to forming the improved carrier extraction layer, can include passivation. For example, chemical passivation can be applied to a back surface of an absorber layer, prior to forming a p-type back contact. For CdTe-based absorber materials, including doped ternary and quaternary alloys comprising similar amounts of cadmium and tellurium, alkaline treatments can produce Cd-rich surfaces. The improved carrier extraction layer may be formed over, and directly contacting, the Cd-rich back surface to form an absorber interface, and a p-type contact layer formed may be formed over, and directly contacting, the improved carrier extraction layer. The described structure can beneficially provide reduced surface recombination velocity at the absorber interface. However this benefit may be negated by high-temperature formation of a p-type back contact layer, such as by depositing a nitrogen-doped zinc telluride layer by vapor transport deposition over the passivated surface of the absorber layer.

For some embodiments, high sustained temperatures may reduce the benefit of the passivation step, damage the improved carrier extraction layer, or may damage other layers of the partially-formed device layer stack. To maintain absorber passivation and layer stack integrity, processing steps following the passivation of the absorber surface can be selected to avoid or limit exposure of the intermediate structure, with the absorber layer over the substrate stack, to high temperatures or other conditions that could cause damage. Many p-type contact materials, including most organic polymer hole-transport materials, are susceptible to damage from heat, moisture, etchants, and some solvents. Because of these limitations, many processes which are used with other photovoltaic devices, or for earlier-deposited layers, may not be suitable for processing steps following an absorber layer Cd-enrichment step and formation of the improved carrier extraction layer.

In some embodiments, a step of depositing a layer, using low temperature methods, is performed by at least one of: thermal evaporation, spray pyrolysis, closed space sublimation (CSS), chemical vapor deposition (CVD), atomic layer deposition (ALD), spin coating, spray coating, slot-die coating, blade coating, roll coating, dip coating, inkjet printing or sol-gel coating. In some embodiments, the step of depositing a layer, using a low temperature method prevents excessive heating of the substrate layer stack during deposition processes and is performed at substrate temperatures at or below 150 °C, at or below 120 °C, or at or below 100 °C.

Passivation of an absorber surface may be performed by an alkaline chemical surface wash, which may further provide surface cleaning, surface organic contamination removal, and oxide removal. The term "wash" or "washing" includes subjecting, exposing, or contacting a wash fluid to a surface, such as the back surface of the absorber layer. By way of non-limiting example, the surface may be at least partially submerged in a bath by dipping it into the wash fluid, or the wash fluid can be applied to the substrate by spraying, coating, painting, flowing, or otherwise allowing the bath to contact at least a portion of the surface. Also, the surfaces of partially-formed devices can be subjected to surface cleaning or passivation in a continuous process, such as by conveyer continuously carrying the substrates into and out of a wash, or in a batch process.

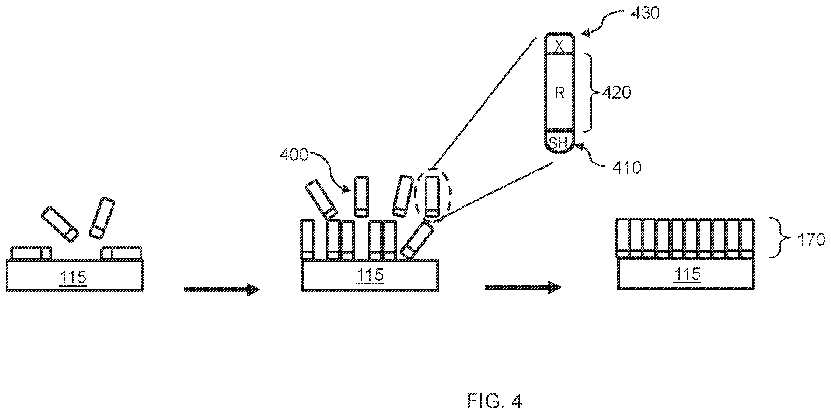

Turning now to FIG. 4, the ICE layer 170 comprises a plurality of molecules 400. Each molecule 400 has a head group 410, a body 420, and may further include a functional end group 430. The head group 410 comprises a thiol, or thiol derivative, having a sulfur atom bonded to a hydrogen (SH). The body 420, or R-group, comprises an organic moiety covalently bound to the head group 410. The functional end group 430, or tail, comprises a functional group, which may be represented as X, and the end group 430 is covalently bound to the body 420. Thus, a structure of a thiol-based molecule for forming the ICE layer 170 may be represented as having a structure of X-R-SH.

The molecules 400 may have strong molecular dipoles. The molecules can orient relative to the substrate, with the head group 410 toward the absorber stack 115. In some embodiments, the oriented molecules form a substantially-contiguous self-assembled monolayer (SAM). The head group 410 may be deprotonated and the sulfur of the head group 410 may bond with Cd atoms at an absorber back surface 164. The structure, composition, and steric properties of the body 420 can regulate packing density of molecules 400 forming the ICE layer and can modulate charge transport. The structure and composition of the end group 430 can modify the dipole moment of the molecules forming the ICE layer 170 and modulate surface work function of the absorber/ICE layer stack. In some embodiments the thiol-based molecule can have a molecular weight in a range of 50-400 daltons or in a range of 100-200 daltons.

FIG. 4 shows a simplified depiction of formation of an example ICE layer 170 on an absorber stack 115. Unbound isolated molecules 400 in solution contact the absorber stack 115 at the absorber back surface 164. Thiol constituents of the head group 410 orient toward the absorber back surface 164. Moving from left to right in FIG. 4, additional molecules 400 aggregate into a substantially ordered layer to form the ICE layer 170 on the absorber stack 115.

The thiol composition may include an X group 430 that increases the polarity and resulting dipole moment of the molecule. These include, for example, electron withdrawing groups such as X groups including fluorine atoms, to yield a dipole direction of negative to positive charge pointing from the X group towards the thiol head. These also include, for example, electron donating groups such as X groups containing amines, to yield a dipole direction of negative to positive charge pointing from the thiol head towards the X group. In some embodiments, the resulting dipole moment across the thiol molecule exceeds 0.5 debye. In some embodiments, the thiol composition comprises an R group 420 that consists of an alkane chain or phenol group. In some embodiments, the thiol composition comprises an R group that is sufficiently small to not sterically restrict bonding to adjacent Cd-sites, facilitating dense molecular packing and bonding to a high proportion of available Cd-sites. In some embodiments, the ICE layer increases the surface workfunction by up to 450meV relative to its value in the absence of an ICE layer. In some embodiments, the ICE layer decreases the surface workfunction by up to 150meV relative to its value in the absence of an ICE layer. In some embodiments, this produces a surface workfunction as high as 5.15eV, or as low as 4.55eV. In some embodiments the ICE layer consists essentially of a single molecular monolayer of a thiol compound.

The ICE layer can be formed on a passivated surface of an absorber layer stack 115. The absorber layer stack 115 can have a Cd-rich layer at a surface region 364. The ICE layer 170 can include a plurality of molecules in which the molecules are dipoles and comprise an organosulfur compound. The ICE layer 170, can be between and directly contacting both the absorber layer 160 and the p-type contact layer 180. The p-type contact layer 180 can include a polymer, a small molecule, or an inorganic compound. Without being bound to theory, applicant has discovered that providing these materials, as described, can produce improved electrical properties when the ICE layer is formed in contact with a type II-VI semiconductor alloy comprising cadmium (Cd). It is further believed that the combination of selected materials can provide a robust structure that is resistant to degradation.

It was discovered that the thiol-based compounds could be paired with CdTe-based absorbers and other type II-VI alloys and further paired with organic and small-molecule p-type contact materials to form the improved carrier extraction layer, to demonstrate a superior combination of optical and electrical properties relative to conventional back contact materials. It was further discovered that selected compositions that can enhance p-type carrier collection are also well suited for use in manufacturing processes.

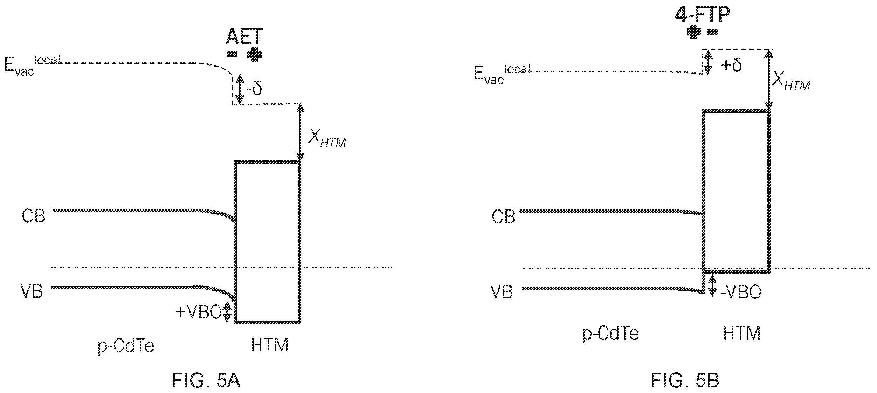

FIG. 5 shows a simplified energy level diagram showing the change in surface work function produced by including either AET or 4-FTP as an improved carrier extraction layer between an absorber layer comprising a CdSeTe alloy and a PTAA p-type contact layer. The energy difference between Fermi energy ($E_F$) and vacuum level corresponds to the work function ($\Phi$). As illustrated by the dashed line, the surface work function of the CdSeTe becomes smaller with the $e^-$-donating X-group tail of AET, giving a more positive valence band offset with PTAA relative to no ICE layer. As illustrated by the dotted line, the surface work function of the CdSeTe becomes larger with the $e^-$-withdrawing X-group tail of 4-FTP, giving a more negative valence band offset with PTAA relative to no ICE layer. As observed in this figure, a smaller or more negative valence band offset (VBO) is produced by the dipole of 4-FTP, as compared to AET, improving transport of holes.

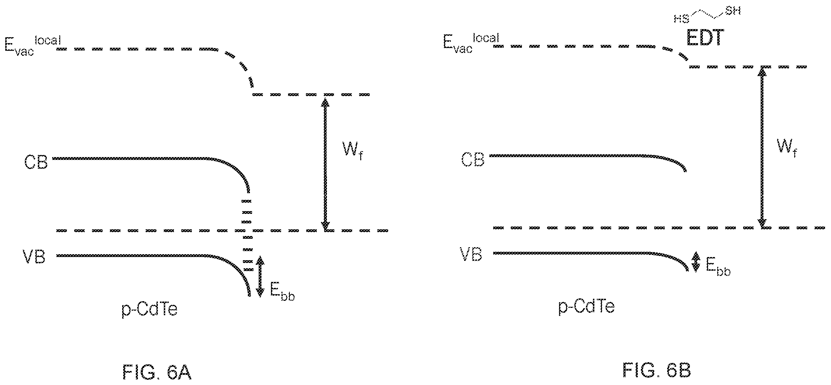

FIGS. 6A and 6B show energy band diagrams for p-type CdTe. FIGS. 6A and 6B show band diagrams of an absorber layer comprising p-type CdTe material, before FIG. 6A, and after FIG. 6B, the EDT layer is applied to the absorber, demonstrating the effects of chemical passivation. Electron energy states (bands) in a material can curve up or down near a junction. This band bending ($E_{bb}$) can be seen for the valence band (VB) and conduction band (CB) in each band diagram; vacuum level ($E_{vac}$), and work function ($W_f$) are also shown. Fermi-level pinning can create an energy barrier for flow of electrons and holes, reducing efficiency. Comparing FIG. 6B with FIG. 6A shows chemical passivation from Cd-S bonding at surface reduces Fermi-level pinning, and improves band-bending. This also affects the work function, which increases after the EDT layer is applied.

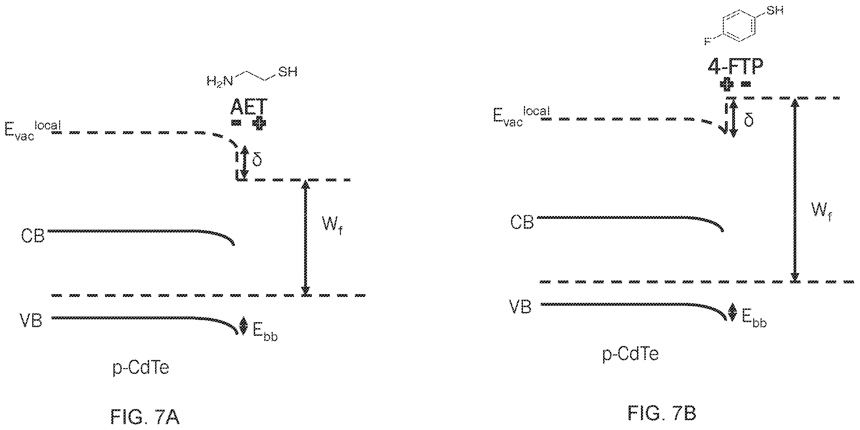

FIGS. 7A and 7B show energy band diagrams for p-type CdTe. FIG. 7A corresponds to a structure having an AET layer. FIG. 7B corresponds to a structure having a 4-FTP layer. FIG. 7A and FIG. 7B show shifting of workfunction in opposite directions due to surface dipole differences in charge. FIG. 7A and FIG. 7B show band diagrams of the absorber layer having the p-CdTe material with either the AET material FIG. 7A or the 4-FTP material FIG. 7B. The work function of the surface can be directly proportional to the change in the dipole caused by the absorption of the ICE layer. As observed in FIGS. 7A and 7B the dipole moment caused by the 4-FTP material FIG. 7B increases the work function when compared to the dipole moment caused by the AET material FIG. 7A.

Changing the material of the ICE layer and changing the positive-negative orientation of a dipole changes whether the work function shifts higher or lower and results in shifts in valence band offset (VBO).

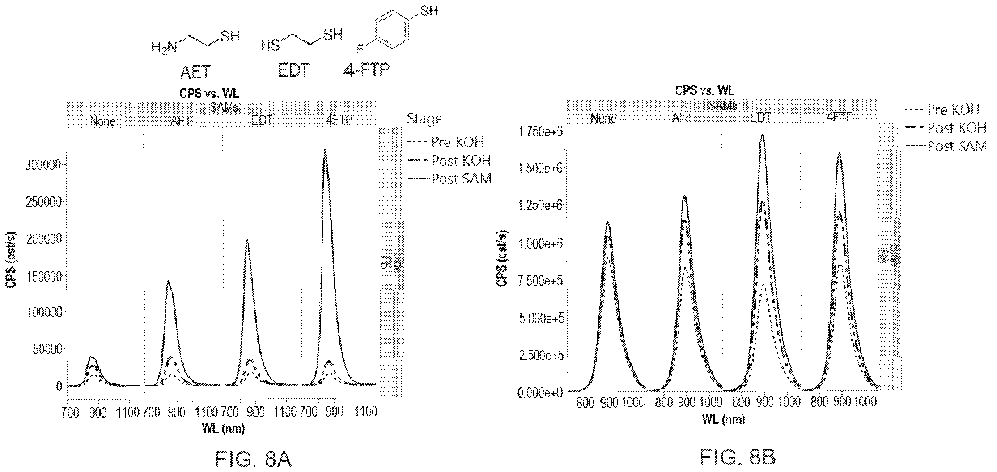

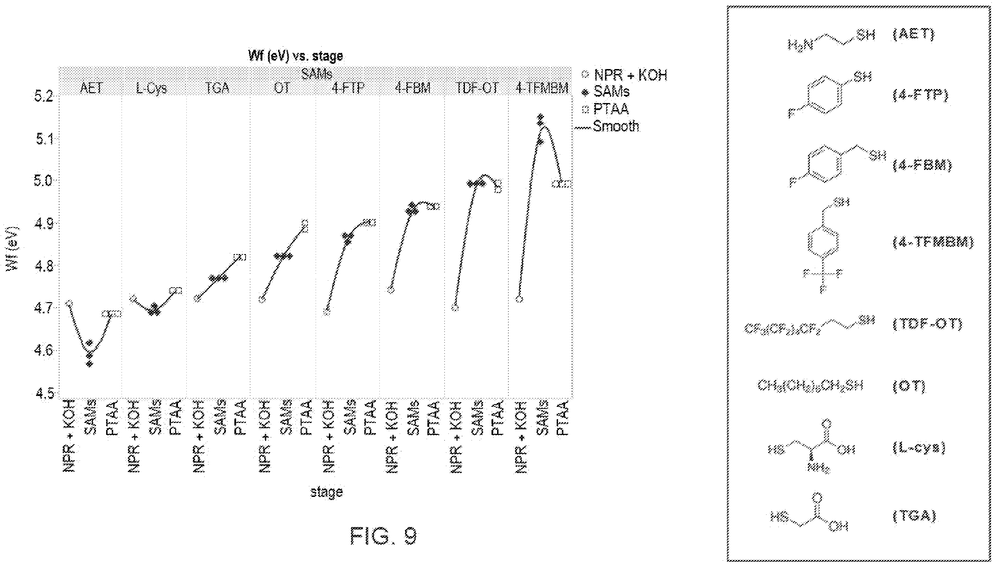

Referring to FIGS. 8A-B and FIG. 9, devices with selected chemical compounds for the ICE layer were produced and tested. The tested materials for the ICE layer included: 2-aminoethanethiol (AET); L-cysteine (L-Cys); thioglycolic acid (TGA); 1-octanethiol (OT); 4-fluorothiophenol (4-FTP); 4-fluorobenzyl mercaptan (4-FBM); 3,3,4,4,5,5,6,6,7,7,8,8,8-tridecafluoro-1-octanethiol (TDF-OT); 4-trifluoromethylbenzyl mercaptan (4-TFMBM); and 1,2-ethanedithiol (EDT).

FIGS. 8A and 8B show graphs of the photoluminescence (PL) intensity for the film side FIG. 8A and the sunny side FIG. 8B of the absorber layer by counts per second (cts/s) and wavelength at different stages. The stages include: a first stage before a potassium hydroxide (KOH) treatment; a second stage after the KOH treatment is applied to the absorber layer, and a third stage after the ICE layer is applied to the absorber layer.

Photoluminescence (PL) can indicate the quality of the active layers of the solar cell. Film-side or back side PL measurements are the more direct measurement of the passivation quality of the back surface. Sunny-side or front side PL is more indicative of the overall minority carrier lifetime within the device, and is less sensitive to back surface treatments and more sensitive to bulk quality. The PL improvement shown in FIGS. 8A-8B relates largely to the chemical passivation at the absorber back interface and does not rely on the presence or direction of a dipole moment. Cd-S bonding reduces the number of dangling Cd bonds at the surface, providing chemical passivation. The observed increase in both front side and back side PL after Cd-rich back surface treatment and after formation of the ICE layer shows this treatment significantly decreases the non-radiative recombination of photogenerated carriers, indicating an influence on solar cell Voc. As can be observed in FIG. 8A, the devices using AET, EDT, and 4-FTP all show at least an order of magnitude increase in PL on the film side. The doubling of the PL corresponds to a 20mV increase in open-circuit voltage (Voc). The PL from the ICE layer and the KOH surface treatments are also apparent in the PL measurements of the sunny side.

Back side PL measurements are the more direct measurement of the passivation quality of the back surface. Front side PL is more indicative of the overall minority carrier lifetime within the device, and so is less sensitive to back surface treatments and more sensitive to bulk and front-interface quality. The observed increase in both front side and back side PL after Cd-rich back surface treatment and after formation of the ICE layer shows this treatment significantly decreases the non-radiative recombination of photogenerated carriers diffusing from the front side, indicating a positive influence on solar cell Voc.

FIG. 9 shows a graph comparing the surface workfunction (Wf) as measured by vibrating Kelvin Probe measurements of contact potential difference (CPD) of the absorber layer at different stages. The stages include: a first stage where the absorber layer has a liquid photoresist (NPR) and KOH treatment; a second stage where the absorber layer also includes the ICE layer; and a third stage where the absorber layer further includes a poly [bis(4-phenyl)(2,4,6-trimethylphenyl)amine (PTAA) layer. Kelvin probe techniques were utilized to determine the CPD, which can be directly correlated to the work function of the absorber layer at the different stages. The CPD can be defined as a potential difference between a point close to a surface of the absorber layer at the different stages, and a point close to a surface of the kelvin probe. CPD can be further related to the work function by the formula,

$$V_{CPD} = \left( \frac{\Phi sample - \Phi probe}{e} \right)$$ , wherein, $V_{CPD}$

is the CPD, $\Phi$sample is the work function of sample (the absorber layer at different stages), $\Phi$probe is the work function of the probe, and e is the elementary charge.

As shown in FIG. 9, different materials for the ICE layer directly affect the tuneability of the surface workfunction, which can be directly correlated to the work function. Notably, it can be observed that three materials, the 4-FBM, the TDF-OT, and the 4-TFMBM, have stronger dipoles than the 4-FTP. The work function of the surface can be directly proportional to the change in the dipole caused by the ICE layer. Experimental data indicate that OT and 4-FTP have a dipole polarity which shifts the band alignment with the PTAA to improve the carrier selectivity of the PTAA contact. This improves the conductivity for holes, while promoting reflection of electrons.

The comparative performance characteristics shown in FIGS. 6-8 and in the comparative testing results indicate that the tested structures were efficacious. Good efficiency, stabilized absorber surface passivation, improvements in fill factor (FF), low charge carrier recombination, low shunting, and good carrier concentration levels were observed. The metrics show the tested structures performed similar or superior to controls in multiple parameters.

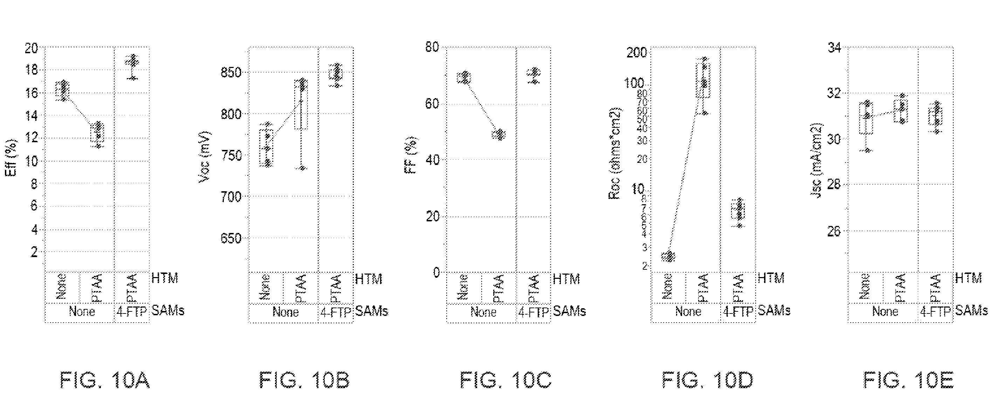

FIGS. 10A-10E show comparative performance characteristics, including measurements of efficiency, open-circuit voltage (Voc), fill factor (FF), open circuit resistance ($R_{OC}$), and short-circuit current density ($J_{SC}$). In this set of measurements, example devices were prepared with an alkaline passivation of an absorber layer, comprising cadmium and tellurium, followed by application of 4-FTP, as an interfacial carrier enhancement layer, and PTAA as a p-type contact layer. Both examples and comparative devices were treated by contacting the second surface of the absorber with an alkaline passivation agent. In a set of comparative devices (left column), a back contact was applied directly over the absorber layer. In another set of comparative devices (middle column), a p-type contact layer comprising PTAA was applied directly over the absorber layer, with a back contact applied directly over the PTAA. In example devices (right column), an ICE layer, comprising 4-FTP, was applied directly over the absorber layer, and a p-type contact layer comprising PTAA was applied directly over the ICE layer, with a back contact applied directly over the PTAA. Results show superior performance of the experimental devices in efficiency, open-circuit voltage, and fill factor. The experimental devices showed comparable performance in short-circuit current density. Data indicate that the experimental devices improve hole transport, and maintain or enhance absorber layer passivation.

Without wishing to be bound by theory, the ICE layer can consist essentially of a self-assembled monolayer with sulfur atoms of the thiol-based compound binding to cadmium of the absorber surface. Through unpinning the surface Fermi level with effective passivation and/or providing additional field through a built-in dipole, the ICE layer can modulate band alignment between layers, such as between the absorber and p-type contact. The p-type contact layer can comprise a hole transport material (HTM), such as an organic, inorganic, or small molecule composition.

Hole transport materials (HTMs) have high hole mobility and a low electron affinity. Thus, when minority carriers (electrons) reach the back contact interface, the HTM blocks their transport through the p-type contact and minimizes interfacial recombination, while allowing facile transport of majority carriers (holes). The p-type contact layer can be deposited at low temperature to prevent damage to the ICE layer and preserve the chemically passivated state of the absorber surface. The p-type contact layer can be deposited on the ICE layer, which may be formed on a cadmium-rich or stoichiometric CdTe-containing surface in which the cadmium-rich or stoichiometric surface can be prepared by treating as-grown CdTe polycrystalline films with one or more basic solutions, such as potassium hydroxide or tetramethylammonium hydroxide.

The p-type contact layer which can be formed over the ICE layer has a large conduction band offset with CdTe to block electrons from recombining at the metal contact and a small valence band offset to allow efficient hole transport. As the diffusion length of photogenerated minority carriers becomes comparable to the thickness of the absorber films, the value of the back contact surface recombination velocity can contribute significantly to the overall device recombination current. Additionally, for bifacial solar cell design, reduction in back contact surface recombination has a strong impact on the open circuit voltage and the potential for efficiency gains from back-side illumination. Reductions in back contact recombination rates can allow for photovoltaic devices with improved minority carrier lifetimes and higher open circuit voltages (Voc).

In an example method, a device is prepared. A TCO on glass may function as a front electrode. An absorber can be directly deposited on the TCO layer or may be deposited onto a buffer layer or a transparent layer over the TCO layer to form an absorber stack. The absorber material may include CdTe and other alloys of II-VI semiconductors, for example, sublayers of cadmium telluride selenide with cadmium telluride, cadmium zinc telluride, cadmium selenide, and/or zinc telluride. The absorber may be doped. A surface treatment can be performed on the absorber surface. The treatment may include doping, passivating the surface with a cadmium chloride heat treatment, cleaning the surface with an acid or base and/or removing oxides. In an example process the absorber stack may be subjected to a chloride heat treatment followed by a potassium hydroxide (KOH) alkaline wash, forming a passivated surface and a Cd-rich back interface of the absorber at the back surface region of the absorber stack. The thiol-based molecule material may then be deposited over and in contact with the treated surface of the absorber layer to form the improved carrier extraction (ICE) layer. The p-type contact material may then be deposited over and in contact with the ICE layer.

In order to passivate an absorber surface in preparation for forming the ICE layer, it may be desirable to reduce surface Te dangling bonds and adjust surface stoichiometry to a desired ratio, and an alkaline etch or passivation with a wash fluid may be performed. In an example, a method for modulating the surface stoichiometry of a II-VI semiconductor material, includes adjusting the concentration of the wash fluid to achieve a desired stoichiometric ratio on the surface of the semiconductor material and subjecting the semiconductor material to a passivation wash with the wash fluid. The pH of the wash fluid can be adjusted to modify a surface ratio of Cd to Te in an absorber stack comprising an absorber layer comprising a II-VI semiconductor material alloy including cadmium and tellurium. Using an alkaline wash with a pH level between about 8 and 14, for example, a substantially stoichiometric CdTe surface can be modified to have a Cd-rich surface. In some embodiments, a wash fluid pH level is between 11 and 13. The wash passivation can be used to optimize back-contact surface chemical and electronic properties.

In some embodiments, the wash fluid comprises a hydroxide. In some embodiments, the wash fluid comprises an aqueous solution of sodium hydroxide (NaOH), potassium hydroxide (KOH), or tetramethylammonium hydroxide ($(CH_3)_4N(OH)$) also referred to as TMAH. In some embodiments, the wash fluid comprises KOH. In some embodiments, the wash fluid comprises KOH at a concentration ranging from about 0.001 M to about 11.67 M, in a range from 0.500 M to 4.000 M, in a range from 1.500 M to 2.750 M, or in a range from 1.750 M to 2.000 M. In some embodiments, the wash fluid comprised KOH at 1.50 to 2.00 M. In some embodiments, the wash fluid is contacted to the surface for a contact time in a range of 10 seconds to 90 minutes. In some embodiments, the contact time is in a range of 30 seconds to 30 minutes, or in a range of 30 seconds to 10 minutes. In some embodiments, the contact time is 1 minute. In some embodiments, the wash fluid temperature is in a range of 0 °C to 90 °C. In some embodiments, the wash fluid temperature is in a range of 20 °C to 30 °C. In some embodiments, the wash fluid temperature is in a range of 5 °C to 50 °C or in a range of 15 °C to 35 °C. In some embodiments, the absorber surface is rinsed with water after contacting with KOH.

In some embodiments, a ratio of Cd to Te at the Cd-rich surface region of the absorber layer is in a range from 1:1 to 4:1. In some embodiments, a ratio of Cd to Te at the Cd-rich surface region of the absorber layer is greater than 1:1. In some embodiments, a ratio of Cd to Te at the Cd-rich surface of the absorber layer as measured by XPS is between 1.3:1 to 2.5:1.

An improved carrier extraction (ICE) layer is formed over the treated absorber stack. In some embodiments, the ICE layer is formed in contact with a Cd-rich surface region of the absorber layer.

In an example, the thiol-based molecule material is provided in a solution having a concentration of about 0.01M - 0.1 M in ethanol and the solution is contacted to the passivated back surface of the absorber stack for a duration ranging from 20 minutes to 36 hours.

In some embodiments, the contact duration is in a range of 30 minutes to 180 minutes. In some embodiments, the sample is rinsed with ethanol to remove aggregates from the surface and placed in an ethanol ultrasonic bath for between 1 and 20 minutes before drying with compressed air or nitrogen.

The p-type contact material can be directly deposited on the ICE layer by various methods including, for example, sputtering, spin coating, or evaporation. In an example, the p-type contact material comprises PTAA. In an example, the structure of the thin film junction stack formed is TCO / CdSeTe / CdTe:As / 4-FTP / PTAA. The partly-formed device stack may then be subjected to a heat treatment, for example, heating at 80-150 C for a period of 30-120 minutes. The post deposition heat treatment of the p-type contact may be performed using a hot plate, an oven, and/or a pressure-controlled heating chamber. A conductive material may then be applied over the p-type contact layer.

In an example, a device with a nickel oxide (NiOx) p-type contact layer is prepared. The device is formed with a NiOx layer adjacent to an arsenic-doped p-type absorber comprising a type II-VI alloy comprising cadmium, tellurium, and selenium.

Nickel oxide (NiOx) based layers have excellent chemical and thermal stabilities which facilitate manufacturing by maintaining critical properties despite high temperatures and chemical passivation steps which may be used in subsequent processing steps following its deposition. High temperatures or extended heating can have a detrimental effect on some layers or components of a device, however, NiOx is resistant to these same conditions. NiOx does not react with arsenic dopants. NiOx has excellent chemical stability, low optical absorption, and relative high mobility as compared to organic p-type charge carrier contact layers. It has a high conduction band edge and provides electron blocking. P-type conductivity in undoped NiOx is largely from nickel vacancies.

NiOx can be deposited by many different methods. For example, preparation of a NiOx layer may be accomplished by sputtering, pulsed laser deposition, or by thermal decomposition of nickel salts such as its chloride, nitrate, or acetate. A NiOx layer may be doped during deposition. In some embodiments, it is beneficial to form a NiOx film with a thickness of only a few nanometers for the p-type contact layer. It is often difficult to deposit an ultra-thin NiOx layer with high film quality.

In some embodiments, it is beneficial to form a p-type contact layer, such as a NiOx film, using low temperature methods to prevent damage to underlying layers of the layer stack or to preserve a chemically-passivated state of a surface of the absorber layer. While NiOx is tolerant to high processing temperatures, it can also be formed without using high-heat methods. In an example, a nickel oxide layer is formed using a sol gel prepared from precursors including nickel compounds, such as nickelbis(acetylacetonate) or nickel(acac)$_2$. The nickel compounds are dissolved in a solvent, such as 2-methoxyethanol (EGME) or methoxypropanol (PGME). A chelating base, such as triethanol amine (TEOA) is added to form a sol gel mixture. Optionally dopants are added to the sol gel mixture. The mixture is then sonicated to form the sol gel. The sol gel is coated onto the partly-formed device. In an example, a sol gel coating can be formed by dipping, roll coating, spray coating, blade coating, or spin coating. NiOx sol gel coatings may be cured by a heat treatment performed at a relatively low temperature or for a short duration to control heat exposure to the layer stack of the partly-formed photovoltaic device.

The NiOx film thickness can be varied in a range from about 2 to 100 nm by changing the concentration of the nickel oxide precursor. The nickel oxide precursor can be a nickel salt. In some embodiments, the NiOx precursor may be one or more of: nickel chloride (NiCl$_2$), nickel nitrate Ni(NO$_3$)$_2$, or nickel acetate Ni(CH$_3$COO)$_2$. In some embodiments, the chelating base is selected from: triethanolamine, diethanolamine, ethanolamine, or tris. In some embodiments, the dopant is selected from: CuCl$_2$, CuCl, CuI, CuSCN, LiCl, LiOAC, KCl, CsCl, CsI, MgCl$_2$, or Mg(OAC)$_2$. In some embodiments, the dopants may include one or more of: Li, Cs, Cu, Mg, Sr, or rare earths such as Er, Tb or Eu. In some embodiments, the NiOx precursor sol gel can be coated once or multiple times to produce the desired thickness. In some embodiments, the curing temperature can be between 40 °C to 400 °C for a duration in a range from 1 minute to 120 minutes. In some embodiments, the curing temperature is less than 350 °C, less than 325 °C, less than 250 °C, or less than 200 °C. In some embodiments, the curing temperature is in a range of 80 °C to 250 °C. In some embodiments, the curing time is between 5 minutes and 60 minutes. In some embodiments, the curing time is between 1 minute and 30 minutes. In some embodiments, the curing time is less than 35 minutes, less than 25 minutes, or less than 15 minutes.

In some embodiments, an absorber layer comprises an n-type material. In some embodiments, a p-n junction is formed by the n-type material of the absorber and one or more p-type layers formed on the absorber stack. The one or more p-type layers formed on the absorber stack can include an ICE layer and a p-type contact layer. In some embodiments, the n-type material of the absorber consists essentially of doped or undoped cadmium selenide.

In some embodiments, the photovoltaic device can include the improved carrier extraction (ICE) layer between the absorber layer and a conductive layer. The device can include a first p-type contact layer between the absorber layer and ICE layer; alternately or additionally, the device can include a second p-type contact layer between the ICE layer and the conductive layer. In some embodiments, the ICE layer can be provided directly adjacent to, and in contact with, one or both of the first p-type contact layer and the second p-type contact layer.

**EP 4 487 383 B1**

Alternately, one or both of the first p-type contact layer and the second p-type contact layer can be omitted and, in some embodiments, the ICE layer is directly adjacent to, and in contact with, one or both of the absorber layer and the conductive layer.

In some embodiments, the p-type contact layer comprises one or more of: an oxide, a nitride, or an oxynitride. In some embodiments, the p-type contact layer comprises one or more of zinc, tellurium, cadmium, or molybdenum. In an example, a composition of the p-type contact layer includes nitrogen-doped zinc telluride, nitrogen-doped cadmium zinc telluride, nitrogen-doped zinc oxide, molybdenum nitride, or molybdenum oxynitride. In some embodiments, the p-type contact layer comprises an inorganic sublayer and an organic sublayer including a polymer material or small molecule material.

In an example device, an ICE layer is between and contacting a first p-type contact layer and a p-type absorber; the absorber comprises cadmium, tellurium, and selenium; the first p-type contact layer comprises a polymer material, such as PTAA; and the device includes a second p-type contact layer, for example a layer comprising zinc telluride, over the polymer material; and a conductive layer, for example molybdenum nitride, is provided over the second p-type contact layer.

The ICE layer is provided or formed over, and in contact with, an underlying layer. The underlying layer can include a p-type contact layer and/or an absorber layer. In some embodiments, a noncontiguous p-type layer is formed over the absorber layer and a ICE layer is formed over the noncontiguous p-type contact layer, whereby the ICE layer contacts at least a portion of a top surface of both the absorber layer and the p-type contact layer. In some embodiments the ICE layer is noncontiguous. In some embodiments the ICE layer covers a portion of an underlying layer. In some embodiments, the covered portion is in a range of 10% to 95%, greater than 15%, greater than 20%, greater than 25%, less than of 90%, less than 80%, less than 75%, or less than 60%.

In some embodiments, the ICE layer is formed over, and in contact with, a p-type contact layer comprising zinc and tellurium. In some embodiments, the ICE layer is formed over, and in contact with, a p-type layer comprising one or more of cadmium, zinc, tellurium, nitrogen, oxygen, or selenium. In some embodiments, the ICE layer is formed over, and in contact with, an n-type absorber layer comprising cadmium and selenium.

In some embodiments, the conductive layer can include a conducting material such as, for example, one or more layers of metal, oxide, oxynitride, nitride, or nitrogen-containing metal. In some embodiments, the conductive layer comprises one or more of: oxygen, nitrogen, zinc, tellurium, cadmium, selenium, molybdenum, tungsten, vanadium, silver, nickel, copper, aluminum, titanium, palladium, chrome, molybdenum, gold. In an example embodiment, the conductive layer includes: nitrogen-doped zinc telluride, nitrogen-doped cadmium zinc telluride, nitrogen-doped zinc oxide, molybdenum nitride, or molybdenum oxynitride.

Experimental results indicate that use of an ICE layer can produce, enhance, or maintain chemical passivation of an interface with an adjacent layer and can modify alignment with the workfunction of an adjacent metal-containing layer. In some embodiments, an adjacent layer directly contacting the ICE layer can include one or more of an absorber layer, a p-type contact layer, or a conductive layer.

In some embodiments of methods for making the device, a surface treatment can be performed on the absorber stack surface. The treatment may include passivating the surface with a cadmium chloride heat treatment, applying a dopant, cleaning the surface with an acid or base, and/or removing oxides. In some embodiments, steps for chemical passivation are initiated prior to contacting the absorber stack with a thiol compound. In some embodiments, chemical passivation is performed simultaneously or concurrently with a step of applying a composition comprising molecules for forming the ICE layer to the surface of the layer stack. In some embodiments, chemical passivation is produced by applying a composition comprising molecules for forming the ICE layer to the surface of the layer stack.

In an example process, the absorber stack may be subjected to a chloride heat treatment followed by an alkaline wash whereby a surface region of the absorber stack is chemically passivated. In some embodiments, the top surface of the absorber stack is surface treated by contact with at least one passivating composition. In some embodiments, the passivating composition comprises a sodium salt, a lithium salt, or a potassium salt. In some embodiments, the passivating composition comprises a thiol, an organosulfur compound, a hydroxide, or an acetate. In some embodiments, the passivating composition is selected from the materials consisting of: sodium acetate, betaine, potassium hydroxide, and tetramethylammonium hydroxide.

In some embodiments of the method, following surface treatment of the absorber stack, layers are deposited over the absorber stack using a controlled temperature method. The step of depositing a layer over the absorber stack, using a controlled temperature method, prevents excessive heating of the substrate layer stack during deposition processes by limiting duration of exposure to temperatures at or above 120 °C, to a duration in a range of 0 to 20 minutes, less than 15 minutes, less than 10 minutes, less than 5 minutes, or less than 2 minutes. In some embodiments, the controlled temperature deposition comprises sputtering.

According to embodiments described herein, a photovoltaic device can include an absorber layer on a substrate stack, the absorber layer comprising cadmium. The photovoltaic device can include a p-type back contact layer formed over a back interface of the absorber layer. The photovoltaic device can include an interfacial carrier enhancement (ICE) layer between the absorber layer and the p-type back contact layer, and the ICE layer can directly contact the back interface of the absorber layer. The ICE layer comprises sulfur in a deprotonated thiol compound.

A surface work function of the ICE layer on the layer stack is tunable over a 600 meV range by thiol compound selection. The surface work function may be assessed by Kelvin Probe measurements of surface work function. Use of an ICE layer produces a shift to more favorable band alignment with a p-type contact layer, including a hole transport material (HTM) or back contact layers.

In some embodiments, the surface work function of the ICE layer has a value magnitude within a range of 4.55eV to 5.15eV measured after ICE layer deposition. In some embodiments, the surface work function of the ICE layer has a value magnitude within a range of 4.6eV to 5.0eV measured after HTM layer deposition.

Use of an ICE layer can produce, enhance, or maintain chemical passivation of an interface with a cadmium-containing absorber layer. The absorber layer comprises cadmium and tellurium, and a ratio of Cd to Te is greater than or equal to 1:1 in a surface region of the absorber layer. In some embodiments, the absorber layer comprises tellurium and a ratio of Cd to Te in a surface region of the absorber layer is within a range from 1:1 to 4:1.

The thiol compound comprises at least one of: isothiourea, cysteamine, also known as 2-aminoethanethiol (AET); 4-fluorothiophenol (4-FTP); 4-aminothiophenol (4-ATP); 1,2-ethanedithiol, also known as ethylene mercaptan (EDT); L-cysteine, also known as (R)-2-amino-3-mercaptopropionic acid (L-Cys); thioglycolic acid, also known as mercaptoacetic acid (TGA); 1-octanethiol (OT); 4-fluorobenzyl mercaptan, also known as (4-fluorophenyl)methanethiol (4-FBM); 3,3,4,4,5,5,6,6,7,7,8,8,8-tridecafluoro-1-octanethiol (TDF-OT); or 4-trifluoromethylbenzyl mercaptan (4-TFMBM).

In some embodiments, the thiol compound comprises at least one of: TDF-OT, 4-FTP, OT, AET, or 4-FBM.

In some embodiments, the back contact comprises at least one of: PTAA, poly-TPD, TFB, PF8-TAA, PIF8-TAA, NiOx, or P3HT.

In some embodiments, the photovoltaic device improves p-type carrier lifetime. In some embodiments, average p-type carrier lifetimes are greater than 5.0 ns. In some embodiments, average p-type carrier lifetimes are greater than 10 ns. In some embodiments, average p-type carrier lifetimes are within a range of 10 ns to 20 ns.

The absorber layer of the photovoltaic device comprises a type II-VI semiconductor, wherein the type II material includes cadmium (Cd) and the type VI material includes tellurium (Te); the absorber layer is doped with at least one dopant selected from phosphorus, arsenic, antimony, or bismuth; the ICE layer is directly adjacent to a second surface of the absorber layer at a passivated surface region, and a ratio of Cd to Te is greater than or equal to 1:1. A p-type contact layer of the photovoltaic device is directly adjacent to a second surface of the ICE layer, and the p-type contact layer comprises at least one of PTAA, P3HT, poly-TPD, TFB, TTF-1, PF8-TAA, PIF8-TAA, SGT-407, PCDTBT, SpiroOMeTAD, anthracene-based HTM, polythiophene, semiconducting polymer, NiO, CuSCN, or CuI. In some embodiments, the device comprises a conductive layer on the p-type contact layer.

In some embodiments, the valence band offset with the p-type contact layer is reduced by the presence of the ICE layer.

In some embodiments, energy level barrier heights at an interface with the p-type contact layer are reduced by the presence of the ICE layer. In some embodiments, energy level barrier heights at an interface with the p-type contact layer are reduced by 20 to 150meV by the presence of the ICE layer, as compared to a comparable device lacking an ICE layer. In some embodiments, energy level barrier heights at an interface with the p-type contact layer are reduced by 50 to 450meV by the presence of the ICE layer, as compared to a comparable device lacking an ICE layer.

In some embodiments, hole carrier densities in the p-type contact layer are improved by the presence of the ICE layer. In some embodiments, hole carrier densities in the p-type contact layer are improved by 50% or greater in the presence of the ICE layer, as compared to a comparable device lacking an ICE layer. In some embodiments, this increase in hole carrier densities can yield a decrease in the resistance measured at open circuit voltage of 50% or larger, including resistance reductions exceeding an order of magnitude.

In some embodiments, the surface work function with the presence of an ICE layer is increased by up to 450meV as compared to a surface without an ICE layer, or decreased by up to 150meV with the presence of an ICE layer as compared to a surface without an ICE layer.

According to embodiments described herein, a partly-formed photovoltaic layer stack can include an interfacial carrier enhancement (ICE) layer between an absorber layer on a substrate stack, and a p-type contact layer. The ICE layer comprises a deprotonated thiol compound.

In some embodiments, the partly-formed device, having an absorber layer stack, an ICE layer, and a p-type contact layer, produces a film-side photoluminescence intensity enhancement of two to ten times the photoluminescence intensity as compared to a comparable partly-formed device stack lacking an ICE layer.

In some embodiments, the thin film junction stack of the described device structure may be adapted for use with a tandem photovoltaic device or for use with a bifacial module.

In some embodiments, the ICE layer can have an average transmittance greater than 50% to light having a wavelength between 400 nm and 700 nm. In some embodiments, the ICE layer 170 can have an average transmittance greater than about 50% to light having a wavelength 400 nm to 1000 nm such as, for example, greater than about 85% in one embodiment, or greater than about 90% in another embodiment, or greater than about 95% in further embodiment.

In some embodiments, the ICE layer is provided in a tandem photovoltaic device. The ICE layer may be provided in a tandem bifacial photovoltaic device. In some embodiments, a tandem device has a top cell and a bottom cell, and the top cell comprises the ICE layer.

Methods of making a photovoltaic device are provided. Methods of treating an absorber stack for making a photovoltaic device are provided. Methods of passivating an absorber layer and maintaining passivation by forming an ICE layer in direct contact with the absorber layer are provided. Methods of aligning band structure between an absorber and a p-type contact layer are provided. Methods are provided for tuning a surface workfunction of an ICE layer over a 600 meV range as measured by Kelvin Probe measurements of surface workfunction, wherein the ICE layer is disposed between an absorber layer and a p-type contact layer, thereby yielding a shift to more favorable band alignment with the p-type contact layer.

According to embodiments described herein, a method can include providing a absorber stack having an absorber layer comprising cadmium (Cd). The method can include passivating a surface of the absorber layer to form a passivated surface at a back interface. The method can include forming an improved carrier extraction (ICE) layer over the passivated surface, by depositing molecules of a thiol compound on the passivated surface, wherein the molecules have a dipole moment, whereby the thiol compound forms an ICE layer in direct contact with the back interface of the absorber layer. The method can include forming a p-type back contact layer over the ICE layer.

In some embodiments, the thiol compound comprises a thiophenol or alkanethiol compound.

In some embodiments, the passivating step comprises contacting the surface of the absorber layer with an alkaline passivation agent.

In some embodiments, the thiol compound molecules comprise a head group with a hydrogen-sulfur bond, and the step of forming the ICE layer comprises deprotonating at least a portion of the head group of the molecules, whereby the sulfur of the head group forms a complex with Cd at the passivated surface and substantially aligns molecules of the ICE layer at the back interface, whereby the sulfur of the head region of the molecule is proximate to the absorber, relative to a body of the molecule, and the ICE layer comprises a deprotonated conjugate of the thiol compound.

In some embodiments, the absorber comprises tellurium and a ratio of Cd to Te is greater than or equal to 1:1 in a surface region of the absorber layer.

In some embodiments, the absorber layer comprises a type II-VI semiconductor, wherein the type II material includes cadmium (Cd) and the type VI material includes tellurium (Te); and the absorber layer is doped with at least one dopant selected from phosphorus, arsenic, antimony, or bismuth.

In some embodiments, the ICE layer comprises sulfur, and the sulfur forms a complex with Cd at the passivated surface of the absorber layer.

In some embodiments, the passivating step comprises contacting the surface of the absorber layer with an alkaline passivation agent. In some embodiments, the alkaline passivation agent comprises at least one of: sodium hydroxide (NaOH), potassium hydroxide (KOH), or tetramethylammonium hydroxide ($(CH_3)_4N(OH)$) TMAH. In some embodiments, the passivating step comprises contacting the surface of the absorber layer with an alkaline passivation agent, wherein a surface region of the absorber layer comprises cadmium and tellurium, whereby passivation produces a ratio of Cd to Te in a range from 1:1 to 4:1 in the surface region of the absorber layer. In some embodiments, a ratio of Cd to Te is greater than 1:1 in the surface region of the absorber layer. In some embodiments, a surface region of the absorber layer consists essentially of a CdTe alloy. In some embodiments, a surface region of the absorber layer comprises a region of the absorber layer at the second surface of the absorber layer, and extending into the absorber layer to a depth in a range of 0.2 nm to 15 nm.

In some embodiments, providing the absorber stack comprises forming the absorber layer over a substrate stack, wherein the absorber layer comprises a type II-VI semiconductor, and wherein forming the absorber layer further comprises doping, passivating; and removing surface oxides from the type II-VI semiconductor prior to depositing the ICE layer.

In some embodiments, forming the ICE layer comprises depositing a liquid suspension of one or more thiol compounds onto an absorber layer. In some embodiments, the one or more thiol compounds are deposited by dip-coating, slot-die coating, blade coating, roll coating, spray coating, or spin coating.

In some embodiments, the ICE layer comprises a compound selected from the group consisting of: isothiourea, AET; 4-FTP; 4-ATP; EDT; L-Cys; TGA; OT; 4-FBM; TDF-OT; 4-TFMBM, or combinations thereof. In some embodiments, the ICE layer consists essentially of one compound selected from the group consisting of: isothiourea, AET; 4-FTP; 4-ATP; EDT; L-Cys; TGA; OT; 4-FBM; TDF-OT; or 4-TFMBM. In some embodiments, the ICE layer consists essentially of one compound selected from the group consisting of: TDF-OT, 4-FTP, OT, or 4-FBM.

In some embodiments, the ICE layer comprises a monolayer of thiol ligands with dipole moments aligned relative to the absorber surface. In some embodiments, the ICE layer consists essentially of a monolayer of thiol ligands with dipole moments aligned relative to the absorber surface. In some embodiments, the ICE layer molecules form bonds with the back interface of the absorber layer. In some embodiments, sulfur atoms in the molecules forming the ICE layer bond with cadmium atoms at the back interface of the absorber layer.

In some embodiments, the ICE layer comprises a thiophenol or alkanethiol compound. In some embodiments, the ICE layer comprises a fluorinated thiophenol or fluorinated alkanethiol compound. In some embodiments, the ICE layer comprises a thiophenol or alkanethiol compound with primary amine groups.

In some embodiments, the ICE layer comprises thiol ligands sterically configured to densely bind to adjacent Cd-sites.

In some embodiments, the ICE layer is directly between and in direct contact with both the absorber layer and the p-type contact layer.

In some embodiments, the step of depositing the p-type contact layer is performed at an absorber layer stack temperature at or below 150 °C. In some embodiments, the p-type contact layer is deposited by slot-die coating, blade coating, roll coating, spray coating, spin coating, sputtering, evaporation, or sol-gel formation. In some embodiments, the p-type contact layer comprises at least one of PTAA, P3HT, poly-TPD, TFB, TTF-1, PF8-TAA, PIF8-TAA, SGT-407, PCDTBT, SpiroOMeTAD, anthracene-based HTM, polythiophene, semiconducting polymer, NiO, CuSCN, or CuI.

In some embodiments, the photovoltaic device has a layer comprising sulfur within 20 nm of the absorber layer second surface. In an example, the layer comprising sulfur is detectable by at least one of: Secondary Ion Mass Spectrometry (SIMS), X-ray Photoelectron Spectroscopy (XPS), Fourier Transform Infrared Spectroscopy (FTIR), Auger Electron Spectroscopy (AES), Energy Dispersive Spectroscopy (EDS), Raman Spectroscopy, or Transmission Electron Microscopy (TEM). In an example, the layer comprising sulfur is detectable by XPS depth profile.

In some embodiments, the ICE layer is formed from a thiol composition comprising: isothiourea, AET; 4-FTP; 4-ATP; EDT; L-Cys; TGA; OT; 4-FBM; TDF-OT; 4-TFMBM; or combinations thereof. In some embodiments, the thiol composition comprises an X group that increases the polarity and resulting dipole moment of the molecule, including for example fluorine atoms or amines. In some embodiments the resulting dipole moment across the thiol molecule exceeds 0.5 debye. In some embodiments, the thiol composition comprises an R group that consists of an alkane chain or phenol group. In some embodiments, the thiol composition comprises an R group that is sufficiently small to not sterically restrict bonding to adjacent Cd-sites, facilitating dense molecular packing and bonding to a high proportion of available Cd-sites. In some embodiments, the ICE layer increases the surface workfunction by up to 450meV relative to its value in the absence of an ICE layer, or decreases the surface workfunction by up to 150meV relative to its value in the absence of an ICE layer. In some embodiments, the ICE layer increases the surface workfunction upwards relative to its value in the absence of an ICE layer and is increased by between 50meV to 450meV, by between 75meV to 400meV, by at least 100meV, by at least 150meV, or by 200meV. In some embodiments, the ICE layer is selected to decrease the surface workfunction relative to its value in the absence of an ICE layer and is decreased by between 25meV and 150meV, between 50meV and 125meV, by at least 100meV, by 75meV, or by 50meV. In some embodiments, this produces a surface workfunction as high as 5.15eV, or as low as 4.55eV. In some embodiments the ICE layer consists essentially of a single molecular monolayer of a thiol compound. In some embodiments, the ICE layer consists essentially of a thiol compound selected from: isothiourea, AET; 4-FTP; 4-ATP; EDT; L-Cys; TGA; OT; 4-FBM; TDF-OT; or 4-TFMBM.

In some embodiments, the thiol compound has a molecular dipole of strength greater than 0.5 debye. In some embodiments, the thiol compound has a molecular dipole of strength in a range of 0.5 to 11.0 debye. In some embodiments, the thiol compound has a dipole moment in a range of 1.5 to 8.5 debye. In some embodiments, the thiol compound has a molecular dipole moment in a range of about 0.5 debye to about 6 debye.

According to embodiments described herein, an ICE layer for a photovoltaic device is provided. In some embodiments the ICE layer is provided with a substantially uniform thickness over the entirety of a directly adjacent passivated absorber layer surface. In some embodiments the ICE layer is provided with substantially continuous coverage of 90% to 100% in a substantially uniform thickness over the directly adjacent absorber layer surface.

In some embodiments, the p-type contact layer comprises an HTM layer in contact with the ICE layer, wherein the HTM layer has a continuous or noncontinuous coverage with thickness of 0.5 nm to 500 nm. In some embodiments the thickness of the p-type contact layer is in a range between 0.5 nm and 100 nm, between 5 nm and 200 nm, between 5 nm and 50 nm, between 10 nm to 100 nm, or between 10 nm and 50 nm.

In an example, a p-type contact layer comprises at least one HTM selected from: semiconducting polymers, polytriarylamine, PTAA, poly-TPD, TFB, PF8-TAA, PIF8-TAA, P3HT, PDI, CPB, TCTA, TCP, PCDTBT, anthracene-based HTM, Spiro-OMeTAD, NiOx, CuSCN, or CuI, or combinations thereof.

In some embodiments, forming the absorber layer further comprises doping, passivating; and removing oxides from the type II-VI semiconductor prior to depositing the ICE layer.

According to embodiments described herein, a method of making a photovoltaic device is provided and includes the steps and compositions described.

It should now be understood that the ICE layer, alone or in conjunction with a p-type contact layer, can provide ohmic contact with improved passivation to the absorber layer, while providing comparable functionality and reliability relative to known contact layer structures for type II-VI absorber materials. Accordingly, the embodiments provided herein can improve the utility of photovoltaic devices.

It is noted that the terms "substantially" and "about" may be utilized herein to represent the inherent degree of uncertainty that may be attributed to any quantitative comparison, value, measurement, or other representation. These terms are also utilized herein to represent the degree by which a quantitative representation may vary from a stated reference without resulting in a change in the basic function of the subject matter at issue.

While particular embodiments have been illustrated and described herein, it should be understood that various other changes and modifications may be made without departing from the scope of the claimed subject matter. Moreover, although various aspects of the claimed subject matter have been described herein, such aspects need not be utilized in combination. It is therefore intended that the appended claims cover all such changes and modifications that are within the scope of the claimed subject matter.

**Claims**

1. A photovoltaic device (100) comprising:

   an absorber layer (160) on a substrate stack (113), the absorber layer (160) comprising a type II-VI semiconductor, wherein:

      the type II material includes cadmium (Cd) and the type VI material includes tellurium (Te);
      the absorber layer (160) is doped with at least one dopant selected from phosphorus, arsenic, antimony, or bismuth; and
      the absorber layer (160) has a first surface (162) facing a front side (102) of the photovoltaic device (100) and a second surface (164) facing a back side (104) of the photovoltaic device (100);

   a p-type contact layer (180) formed over a back interface at a second surface (164) of the absorber layer (160);
   an improved carrier extraction layer (170) between the absorber layer (160) and the p-type contact layer (180), wherein:

      the improved carrier extraction layer (170) is directly adjacent to the second surface (164) of the absorber layer (160) at a passivated surface region, wherein a ratio of Cd to Te in the passivated surface region is equal to or greater than 1:1;
the improved carrier extraction layer (170) has a first surface (172) facing the front side (102) of the photovoltaic device (100) and a second surface (174) facing the back side (104) of the photovoltaic device (100);
the improved carrier extraction layer (170) comprises sulfur in a thiol compound that is deprotonated; and

   a surface workfunction of the improved carrier extraction layer on the absorber layer is tunable by selection of thiol compound over a 600 meV range as measured by Kelvin Probe measurements of surface workfunction

      the thiol compound comprises at least one of: isothiourea, 2-aminoethanethiol (AET); 4-fluorothiophenol (4-FTP); 4-aminothiophenol (4-ATP); 1,2-ethanedithiol (EDT); L-cysteine (L-Cys); thioglycolic acid (TGA); 1-octanethiol (OT); 4-fluorobenzyl mercaptan (4-FBM); 3,3,4,4,5,5,6,6,7,7,8,8,8-tridecafluoro-1-octanethiol (TDF-OT); or 4-trifluoromethylbenzyl mercaptan (4-TFMBM);
      the p-type contact layer (180) is directly adjacent to the second surface (174) of the improved carrier extraction layer (170);
      the p-type contact layer (180) comprises at least one of: PTAA, P3HT, poly-TPD, TFB, TTF-1, PF8-TAA, PIF8-TAA, SGT-407, PCDTBT, SpiroOMeTAD, anthracene-based HTM, polythiophene, semiconducting polymer, NiO, CuSCN, or CuI; and

   a conductive layer (190) on the p-type contact layer (180).

2. The photovoltaic device of claim 1, wherein a ratio of Cd to Te is greater than 1:1 in the passivated surface region of the absorber layer (160).

3. The photovoltaic device (100) of claim 1, wherein a ratio of Cd to Te in the passivated surface region of the absorber layer (160) is within a range from 1:1 to 4:1.

4. The photovoltaic device (100) of any of claims 1-3, wherein the thiol compound has a molecular dipole of strength greater than 0.5 debye.

5. The photovoltaic device (100) of any of claims 1-4, wherein the surface workfunction of the carrier extraction layer (170) has a value magnitude within a range of 4.55 eV to 5.15 eV.

6. The photovoltaic device (100) of any of claims 1-4, wherein a surface workfunction of the p-type contact layer (180) has a value magnitude within a range of 4.6 eV to 5.0 eV.

7. The photovoltaic device (100) of any of claims 1-6, wherein the thiol compound comprises at least one of: TDF-OT, 4-FTP, OT, AET, or 4-FBM.

8. The photovoltaic device (100) of any of claims 1-7, wherein the p-type contact layer (180) comprises at least one of: PTAA, poly-TPD, TFB, PF8-TAA, PIF8-TAA, NiO, or P3HT.

9. The photovoltaic device (100) of any of claims 1-8, wherein surface workfunction with the presence of the carrier extraction layer (170) is increased by up to 450meV as compared to a surface without the carrier extraction layer (170), or decreased by up to 150meV with the presence of the carrier extraction layer (170) as compared to a surface without the carrier extraction layer (170).

10. The photovoltaic device (100) of any of claims 1-9, wherein a valence band offset with the p-type contact layer (180) is reduced by the presence of the carrier extraction layer (170).

11. The photovoltaic device (100) of any of claims 1-10, wherein energy level barrier heights at an interface with the p-type contact layer (180) are reduced by the presence of the carrier extraction layer (170).

12. The photovoltaic device of any of claims 1-11, wherein hole carrier densities in the p-type contact layer are increased by the presence of the carrier extraction layer (170).

13. The photovoltaic device (100) of any of claims 1-12, wherein the carrier extraction layer (170) has a thickness in a range from 0.2 nm to 5.0 nm.

**Patentansprüche**

1. Photovoltaikvorrichtung (100) umfassend:
   eine Absorberschicht (160) auf einem Substratstapel (113), wobei die Absorberschicht (160) einen Typ-II-VI-Halbleiter umfasst, wobei:

   das Typ-II-Material Cadmium (Cd) umfasst und das Typ-VIMaterial Tellur (Te) umfasst;
   die Absorberschicht (160) mit wenigstens einem Dotierstoff ausgewählt aus Phosphor, Arsen, Antimon und Bismut dotiert ist; und
   die Absorberschicht (160) eine erste Oberfläche (162), die einer Vorderseite (102) der Photovoltaikvorrichtung (100) zugewandt ist, und eine zweite Oberfläche (164), die einer Rückseite (104) der Photovoltaikvorrichtung (100) zugewandt ist, aufweist;
eine p-Typ-Kontaktschicht (180), die über einer rückseitigen Grenzfläche an einer zweiten Oberfläche (164) der Absorberschicht (160) gebildet ist;
eine verbesserte Trägerextraktionsschicht (170) zwischen der Absorberschicht (160) und der p-Typ-Kontaktschicht (180), wobei:

die verbesserte Trägerextraktionsschicht (170) an einem passivierten Oberflächenbereich direkt an die zweite Oberfläche (164) der Absorberschicht (160) angrenzt, wobei ein Verhältnis von Cd zu Te in dem passivierten Oberflächenbereich gleich oder größer als 1:1 ist;
die verbesserte Trägerextraktionsschicht (170) eine erste Oberfläche (172), die der Vorderseite (102) der Photovoltaikvorrichtung (100) zugewandt ist, und eine zweite Oberfläche (174), die der Rückseite (104) der Photovoltaikvorrichtung (100) zugewandt ist, aufweist;
die verbesserte Trägerextraktionsschicht (170) Schwefel in einer Thiolverbindung, die deprotoniert ist, umfasst; und
eine Oberflächenaustrittsarbeit der verbesserten Trägerextraktionsschicht auf der Absorberschicht durch Auswählen der Thiolverbindung über einen 600 MeV-Bereich abstimmbar ist, wie gemessen durch Kelvinsondenmessungen der Oberflächenaustrittsarbeit, wobei die Thiolverbindung wenigstens eines umfasst von: Isothioharnstoff, 2-Aminoethanthiol (AET); 4-Fluorthiophenol (4-FTP); 4-Aminothiophenol (4-ATP); 1,2-Ethandithiol; L-Cystein (L-Cys); Thioglycolsäure (TGA); 1-Octanthiol (OT); 4-Fluorbenzylmercaptan (4-FBM); 3,3,4,4,5,5,6,6,7,7,8,8,8-Tridecafluor-1-octanthiol (TDF-OT); und 4-Trifluormethylbenzylmercaptan (4-TFMBM); die p-Typ-Kontaktschicht (180) direkt an die zweite Oberfläche (174) der verbesserten Trägerextraktionsschicht (170) angrenzt;
die p-Typ-Kontaktschicht (180) wenigstens eines umfasst von: PTAA, P3HT, poly-TPD, TFB, TTF-1, PF8-TAA, PIF8-TAA, SGT-407, PCDTBT, SpiroOMeTAD, HTM auf Anthracenbasis, Polythiophen, halbleitendem Polymer, NiO, CuSCN und CuI; und
eine leitfähige Schicht (190) auf der p-Typ-Kontaktschicht (180).

2. Photovoltaikvorrichtung nach Anspruch 1, wobei ein Verhältnis von Cd zu Te in dem passivierten Oberflächenbereich der Absorberschicht (160) größer als 1:1 ist.

3. Photovoltaikvorrichtung (100) nach Anspruch 1, wobei ein Verhältnis von Cd zu Te in dem passivierten Oberflächenbereich der Absorberschicht (160) in einem Bereich von 1:1 bis 4:1 liegt.

4. Photovoltaikvorrichtung (100) nach einem der Ansprüche 1-3, wobei die Thiolverbindung einen molekularen Dipol mit einer Stärke von mehr als 0,5 Debye aufweist.

5. Photovoltaikvorrichtung (100) nach einem der Ansprüche 1-4, wobei die Oberflächenaustrittsarbeit der Trägerextraktionsschicht (170) einen Wert in einer Größenordnung in einem Bereich von 4,55 eV bis 5,15 eV aufweist.

6. Photovoltaikvorrichtung (100) nach einem der Ansprüche 1-4, wobei eine Oberflächenaustrittsarbeit der p-Typ-Kontaktschicht (180) einen Wert in einer Größenordnung in einem Bereich von 4,6 eV bis 5,0 eV aufweist.

7. Photovoltaikvorrichtung (100) nach einem der Ansprüche 1-6, wobei die Thiolverbindung wenigstens eines umfasst von: TDF-OT, 4-FTP, OT, AET und 4-FBM.

8. Photovoltaikvorrichtung (100) nach einem der Ansprüche 1-7, wobei die p-Typ-Kontaktschicht (180) wenigstens eines umfasst von: PTAA, Poly-TPD, TFB, PF8-TAA, PIF8-TAA, NiO und P3HT.

9. Photovoltaikvorrichtung (100) nach einem der Ansprüche 1-8, wobei die Oberflächenaustrittsarbeit mit dem Vorhandensein der Trägerextraktionsschicht (170) im Vergleich zu einer Oberfläche ohne die Trägerextraktionsschicht (170) um bis zu 450 meV erhöht ist oder mit dem Vorhandensein der Trägerextraktionsschicht (170) im Vergleich zu einer Oberfläche ohne die Trägerextraktionsschicht (170) um bis zu 150 meV verringert ist.

10. Photovoltaikvorrichtung (100) nach einem der Ansprüche 1-9, wobei ein Valenzbandversatz mit der p-Typ-Kontaktschicht (180) durch das Vorhandensein der Trägerextraktionsschicht (170) verringert ist.

11. Photovoltaikvorrichtung (100) nach einem der Ansprüche 1-10, wobei Energieniveaubarrierehöhen an einer Grenzfläche mit der p-Typ-Kontaktschicht (180) durch das Vorhandensein der Trägerextraktionsschicht (170) verringert sind.

12. Photovoltaikvorrichtung nach einem der Ansprüche 1-11, wobei Lochträgerdichten in der p-Typ-Kontaktschicht durch das Vorhandensein der Trägerextraktionsschicht (170) erhöht sind.

13. Photovoltaikvorrichtung (100) nach einem der Ansprüche 1-12, wobei die Trägerextraktionsschicht (170) eine Dicke in einem Bereich von 0,2 nm bis 5,0 nm aufweist.

**Revendications**

1. Dispositif photovoltaïque (100) comprenant :
une couche d'absorbeur (160) sur un empilement substrat (113), la couche d'absorbeur (160) comprenant un semiconducteur de type II-VI, dans lequel :

le matériau de type II comporte du cadmium (Cd) et le matériau de type VI comporte du tellure (Te) ;
la couche d'absorbeur (160) est dopée avec au moins un dopant choisi parmi le phosphore, l'arsenic, l'antimoine et le bismuth ; et
la couche d'absorbeur (160) a une première surface (162) tournée vers une face avant (102) du dispositif photovoltaïque (100) et une deuxième surface (164) tournée vers une face arrière (104) du dispositif photovoltaïque (100) ;
une couche de contact de type p (180) formée sur une interface arrière au niveau d'une deuxième surface (164) de la couche d'absorbeur (160) ;
une couche d'extraction de porteurs améliorée (170) entre la couche d'absorbeur (160) et la couche de contact de type p (180), dans lequel :

ma couche d'extraction de porteurs améliorée (170) est directement adjacente à la deuxième surface (164) de la couche d'absorbeur (160) au niveau d'une région de surface passivée, un rapport entre Cd et Te dans la région de surface passivée étant égal ou supérieur à 1/1 ;
la couche d'extraction de porteurs améliorée (170) a une première surface (172) tournée vers la face avant (102) du dispositif photovoltaïque (100) et une deuxième surface (174) tournée vers la face arrière (104) du dispositif photovoltaïque (100) ;
la couche d'extraction de porteurs améliorée (170) comprend du soufre dans un composé thiol qui est déprotoné ; et
un travail d'extraction de surface de la couche d'extraction de porteurs améliorée sur la couche d'absorbeur peut être réglé par sélection du composé thiol sur une plage de 600 meV telle que mesurée par des mesures à la sonde Kelvin du travail d'extraction de surface, le composé thiol comprenant au moins un des composés suivants : isothiourée ; 2-aminoéthanethiol (AET) ; 4-fluorothiophénol (4-FTP) ; 4-aminothiophénol (4-ATP) ; 1,2-éthanedithiol (EDT); L-cystéine (L-Cys) ; acide thioglycolique (TGA) ; 1-octanethiol (OT) ; 4-fluorobenzylmercaptan (4-FBM) ; 3,3,4,4,5,5,6,6,7,7,8,8,8-tridécafluoro-1-octanethiol (TDF-OT) ; et 4-trifluorométhylbenzylmercaptan (4-TFMBM) ;

la couche de contact de type p (180) est directement adjacente à la deuxième surface (174) de la couche d'extraction de porteurs améliorée (170) ;

la couche de contact de type p (180) comprend au moins un des composés suivants : PTAA, P3HT, poly-TPD, TFB, TTF-1, PF8-TAA, PIF8-TAA, SGT-407, PCDTBT, SpiroOMeTAD, HTM à base d'anthracène, polythiophène, polymère semiconducteur, NiO, CuSCN, et CuI ; et

une couche conductrice (190) sur la couche de contact de type p (180).

2. Dispositif photovoltaïque de la revendication 1, dans lequel un rapport entre Cd et Te est supérieur à 1/1 dans la région de surface passivée de la couche d'absorbeur (160).

3. Dispositif photovoltaïque (100) de la revendication 1, dans lequel un rapport entre Cd et Te dans la région de surface passivée de la couche d'absorbeur (160) est compris entre 1/1 et 4/1.

4. Dispositif photovoltaïque (100) de l'une quelconque des revendications 1 à 3, dans lequel le composé thiol présente un dipôle moléculaire d'intensité supérieure à 0,5 debye.

5. Dispositif photovoltaïque (100) de l'une quelconque des revendications 1 à 4, dans lequel le travail d'extraction de surface de la couche d'extraction de porteurs (170) a une amplitude de valeur comprise entre 4,55 eV et 5,15 eV.

6. Dispositif photovoltaïque (100) de l'une quelconque des revendications 1 à 4, dans lequel un travail d'extraction de surface de la couche de contact de type p (180) a une amplitude de valeur comprise entre 4,6 eV et 5,0 eV.

7. Dispositif photovoltaïque (100) de l'une quelconque des revendications 1 à 6, dans lequel le composé thiol comprend au moins un des composés suivants : TDF-OT, 4-FTP, OT, AET, et 4-FBM.

8. Dispositif photovoltaïque (100) de l'une quelconque des revendications 1 à 7, dans lequel la couche de contact de type p (180) comprend au moins un des composés suivants : PTAA, poly-TPD, TFB, PF8-TAA, PIF8-TAA, NiO, et P3HT.

9. Dispositif photovoltaïque (100) de l'une quelconque des revendications 1 à 8, dans lequel le travail d'extraction de surface en présence de la couche d'extraction de porteurs (170) est augmenté de 450 meV maximum par rapport à une surface sans la couche d'extraction de porteurs (170), ou diminué de 150 meV maximum en présence de la couche d'extraction de porteurs (170) par rapport à une surface sans la couche d'extraction de porteurs (170).

10. Dispositif photovoltaïque (100) de l'une quelconque des revendications 1 à 9, dans lequel un décalage de bande de valence avec la couche de contact de type p (180) est réduit par la présence de la couche d'extraction de porteurs (170).

11. Dispositif photovoltaïque (100) de l'une quelconque des revendications 1 à 10, dans lequel les hauteurs de barrière de niveau d'énergie à une interface avec la couche de contact de type p (180) sont réduites par la présence de la couche d'extraction de porteurs (170).

12. Dispositif photovoltaïque de l'une quelconque des revendications 1 à 11, dans lequel les densités de porteurs de trous dans la couche de contact de type p sont augmentées par la présence de la couche d'extraction de porteurs (170).

13. Dispositif photovoltaïque (100) de l'une quelconque des revendications 1 à 12, dans lequel la couche d'extraction de porteurs (170) a une épaisseur comprise entre 0,2 nm et 5,0 nm.

FIG. 1

FIG. 2

FIG. 3A

FIG. 3B

FIG. 4

FIG. 5A

FIG. 5B

FIG. 6B

FIG. 6A

EP 4 487 383 B1

$H_2N$ SH

AET

$E_{vac}^{local}$

$\delta$

CB

$W_f$

VB

$E_{bb}$

p-CdTe

FIG. 7A

SH

4-FTP

$E_{vac}^{local}$

$\delta$

CB

$W_f$

VB

$E_{bb}$

p-CdTe

FIG. 7B

FIG. 8A

FIG. 8B

FIG. 9

FIG. 10A

FIG. 10B

FIG. 10C

FIG. 10D

FIG. 10E

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2008023677 A1

**Non-patent literature cited in the description**

- **I-SHUO LIU et al.** Enhancing photoluminescence quenching and photoelectric properties of CdSe quantum dots with hole accepting ligands. *Journal of Materials Chemistry*, 03 January 2008, vol. 18 (6), 675-682

- **ARIVARASAN AYYASWAMY et al.** Evaluation of Reaction Parameters Dependent Optical Properties and Its Photovoltaics Performances of CdTe QDs. *JOURNAL OF INORGANIC AND ORGANOMETAL-LIC POLYMERS AND MATERIALS*, 19 February 2018, vol. 28 (3)